# EUROPÄISCHE PATENTSCHRIFT

(11) **EP 2 695 213 B1**
(45) Veröffentlichungstag und Bekanntmachung des Hinweises auf die Patenterteilung: **13.11.2019**
(21) Anmeldenummer: 12709287.2
(22) Anmeldetag: 07.03.2012
(51) Int. Cl.: H01L 51/50

(54) **ORGANISCHE ELEKTROLUMINESZENZVORRICHTUNG**
ORGANIC ELECTROLUMINESCENT DEVICE
DISPOSITIF ÉLECTROLUMINESCENT ORGANIQUE

(30) Priorität: 05.04.2011 EP 11002816
(43) Veröffentlichungstag der Anmeldung: 12.02.2014
(73) Patentinhaber: Merck Patent GmbH, 64293 Darmstadt (DE)
(72) Erfinder: PFLUMM, Christof, 64291 Darmstadt (DE); SCHULTE, Niels, 65779 Kelkheim (DE)
(86) Internationale Anmeldenummer: PCT/EP2012/001016
(87) Internationale Veröffentlichungsnummer: WO 2012/136295

(56) Entgegenhaltungen:
- WO-A1-2008/143791
- WO-A1-2010/069442
- WO-A1-2010/108579
- DE-A1-102008 063 490
- US-A1- 2007 252 516
- US-A1- 2009 191 427

## Beschreibung

Die vorliegende Erfindung betrifft phosphoreszierende organische Elektrolumineszenzvorrichtungen, welche eine geringe Konzentration des phosphoreszierenden Emitters in der emittierenden Schicht aufweisen.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, insbesondere auch bei OLEDs, die Triplettemission (Phosphoreszenz) zeigen, jedoch immer noch Verbesserungsbedarf.

Bei OLEDs gemäß dem Stand der Technik werden die phosphoreszierenden Emitter üblicherweise in einer Konzentration von 10 Vol.% oder mehr eingesetzt. Ein Problem beim Einsatz phosphoreszierender Emitter, insbesondere Iridium- oder Platinkomplexen, in der Massenproduktion ist neben der Seltenheit dieser Elemente die nicht immer ausreichende thermische Stabilität. Um hohe Taktzeiten zu erreichen, wären hohe Aufdampfraten wünschenswert. Dies ist jedoch durch die damit verbundene höhere Aufdampftemperatur und dadurch verursachte thermische Zersetzung der Komplexe nur begrenzt möglich. Eine Möglichkeit wäre, die Emitterkonzentration herabzusetzen, wodurch man trotz thermischer Instabilität höhere Taktzeiten erreichen kann, da geringere Aufdampfraten ausreichend wären. Allerdings verringern sich bei Emissionsschichten gemäß dem Stand der Technik die Effizienz und die Lebensdauer erheblich, wenn die Emitterkonzentration deutlich unter 10 Vol.% liegt. Dies gilt insbesondere bei grün oder blau phosphoreszierenden Emittern, während bereits rot emittierende OLEDs bekannt sind, bei denen eine Emitterkonzentration von weniger als 10 Vol.% vorliegt und die gute Eigenschaften zeigen.

Vor allem wird auch das so genannte "Roll-Off"-Verhalten mit abnehmender Emitterkonzentration stärker. Darunter wird verstanden, dass die Effizienz einer organischen Elektrolumineszenzvorrichtung üblicherweise bei hoher Leuchtdichte deutlich geringer ist als bei geringer Leuchtdichte. Man erhält also bei geringen Leuchtdichten eine hohe Effizienz, während man bei hohen Leuchtdichten nur eine geringe Effizienz erhält. Dagegen würde eine höhere Quanteneffizienz bei hoher Leuchtdichte zu einer höheren Leistungseffizienz und somit zu einem geringeren Energieverbrauch der OLED führen.

In OLEDs gemäß dem Stand der Technik beobachtet man weiterhin auch eine vergleichsweise hohe Abhängigkeit der Eigenschaften der Elektrolumineszenzvorrichtung von der Emitterkonzentration. Dies führt zu einem kleinen Prozessfenster in der Massenproduktion, d. h. dass bereits bei kleineren Schwankungen der Aufdampfraten und damit der Emitterkonzentration größere Abweichungen in den Eigenschaften der Elektrolumineszenzvorrichtung beobachtet werden. Es wäre daher für die Prozesssicherheit wünschenswert, eine höhere Toleranz gegenüber Schwankungen in der Aufdampfrate zu erreichen.

In OLEDs gemäß dem Stand der Technik beobachtet man weiterhin, dass die Eigenschaften der OLED wesentlich von der Lage des HOMO bzw. des LUMO des phosphoreszierenden Emitters abhängig sind, vor allem von der Lage des HOMO des Emitters. Dies kann insbesondere bei phosphoreszierenden Platinkomplexen zu Problemen bei der Lochinjektion und somit zu einer verringerten Effizienz und/oder Lebensdauer mit diesen Komplexen führen. Hier sind weitere Verbesserungen wünschenswert.

Die Dokumente US 2007/0252516 A1 und US 2009/0191427 A1 beschreiben organische Elektrolumineszenzvorrichtungen mit phosphoreszierenden Emissionsschichten die eine Emitterkonzentration von weniger als 10 % aufweisen.

Das der vorliegenden Erfindung zu Grunde liegende technische Problem ist daher die Bereitstellung einer phosphoreszierenden organischen Elektrolumineszenzvorrichtung, welche trotz der Verwendung einer geringen Emitterkonzentration von weniger als 10 % ein gutes Roll-Off-Verhalten, eine geringe Abhängigkeit der Emissionseigenschaften von der Emitterkonzentration und/oder eine geringe Abhängigkeit der Emissionseigenschaften von der Lage des HOMO bzw. des LUMO des Emitters zeigt und bei welcher sich außerdem die Effizienz und die Lebensdauer nicht oder zumindest nicht wesentlich verschlechtern gegenüber einer OLED, welche den phosphoreszierenden Emitter in einer Konzentration von 10 Vol.% oder mehr enthält.

Überraschend wurde gefunden, dass dieses Problem durch eine organische Elektrolumineszenzvorrichtung, wie sie im Folgenden beschrieben wird, gelöst wird. Insbesondere wurde beobachtet, dass die Eigenschaften wesentlich von dem Unterschied des HOMO der Elektronenblockierschicht und der emittierenden Schicht und von dem Unterschied des LUMO der Lochblockierschicht und der emittierenden Schicht abhängen.

Gegenstand der Erfindung ist somit eine organische Elektrolumineszenzvorrichtung mit einem Emissionmaximum von ≤ 570 nm enthaltend in dieser Reihefolge eine Anode, eine Elektronenblockierschicht (EBL), eine phosphoreszierende Emissionsschicht (EML), welche mindestens eine phosphoreszierende Verbindung und mindestens ein Matrixmaterial enthält, wobei die Gesamtkonzentration aller phosphoreszierenden Verbindungen < 10 Vol.% ist, eine Lochblockierschicht (HBL) und eine Kathode, wobei die Elektrolumineszenzvorrichtung zwischen der emittierenden Schicht und der Kathode keinen Aluminiummetallkomplex enthält, dadurch gekennzeichnet, dass für die Schichten gilt:
a) $HOMO \left(EBL\right) - HOMO \left(EML\right) \leq 0.4 eV ;$
b) $LUMO \left(EML\right) - LUMO \left(HBL\right) \leq 0.4 eV ;$
c) $HOMO aller Matrixmaterialien der EML \geq - 6.0 eV ;$ und
d) $LUMO \left(EML\right) \leq - 2.5 eV .$

Eine Elektronenblockierschicht im Sinne der vorliegenden Erfindung ist eine Schicht, die auf Anodenseite direkt an die emitterende Schicht angrenzt. Dabei kann die Elektronenblockierschicht auch gleichzeitig die Lochtransportschicht bzw. die Exzitonenblockierschicht sein. HOMO(EBL) ist das HOMO des Materials der Elektronenblockierschicht. Besteht diese Schicht aus mehreren Materialien, so ist HOMO(EBL) das am höchsten liegende HOMO dieser Materialien. LUMO(EBL) ist das LUMO des Materials der Elektronenblockierschicht. Besteht diese Schicht aus mehreren Materialien, so ist LUMO(EBL) das am tiefsten liegende LUMO dieser Materialien.

Eine phosphoreszierende Emissionsschicht im Sinne der Erfindung ist eine Schicht, welche eine phosphoreszierende Verbindung enthält. HOMO(EML) ist das HOMO der Matrixmaterialien der Emissionsschicht. Bei einer Einzelmatrix ist HOMO(EML) das HOMO dieses Matrixmaterials. Bei Verwendung mehrerer Matrixmaterialien ("mixed matrix") ist HOMO(EML) das am höchsten liegende HOMO der Matrixkomponenten. LUMO(EML) ist das LUMO der Matrixmaterialien der Emissionsschicht. Bei einer Einzelmatrix ist LUMO(EML) das LUMO dieses Matrixmaterials. Bei Verwendung mehrerer Matrixmaterialien ("mixed matrix") ist LUMO(EML) das am tiefsten liegende LUMO der Matrixkomponenten.

Eine phosphoreszierende Verbindung im Sinne dieser Erfindung ist eine Verbindung, welche bei Raumtemperatur Lumineszenz aus einem angeregten Zustand mit höherer Spinmultiplizität zeigt, insbesondere aus einem angeregten Triplettzustand. Im Sinne dieser Erfindung sollen alle lumineszierenden Übergangsmetallkomplexe und alle lumineszierenden Lanthanidkomplexe, insbesondere alle lumineszierenden Iridium-, Platin- und Kupferverbindungen, als phosphoreszierende Verbindungen angesehen werden.

Ein Matrixmaterial im Sinne der vorliegenden Erfindung ist jedes Material, das in der emittierenden Schicht vorliegt und das keine phosphoreszierende Verbindung ist.

Eine Lochblockierschicht im Sinne der vorliegenden Erfindung ist eine Schicht, die auf Kathodenseite direkt an die emitterende Schicht angrenzt. Dabei kann die Lochblockierschicht auch gleichzeitig die Elektronentransportschicht sein. LUMO(HBL) ist das LUMO des Materials der Lochblockierschicht. Besteht diese Schicht aus mehreren Materialien, so ist LUMO(HBL) das am tiefsten liegende LUMO dieser Materialien. HOMO(HBL) ist das HOMO des Materials der Lochblockierschicht. Besteht diese Schicht aus mehreren Materialien, so ist HOMO(HBL) das am höchsten liegende HOMO dieser Materialien.

Dabei werden das HOMO (highest occupied molecular orbital), das LUMO (lowest occupied molecular orbital) und das Triplettniveau T₁ durch quantenchemische Rechnungen bestimmt, wie hinten im Beispielteil allgemein erläutert.

Zur Klarstellung wird hier nochmals hervorgehoben, dass es sich bei den Werten für HOMO und LUMO definitionsgemäß um negative Zahlenwerte handelt. Bei dem am höchsten liegenden HOMO bzw. dem höchsten HOMO handelt es sich daher um das betragsmäßig kleinste HOMO, und bei dem am tiefsten liegenden LUMO bzw. dem tiefsten LUMO handelt es sich um das betragsmäßig größte LUMO.

Unter dem Emissionsmaximum im Sinne der vorliegenden Erfindung wird das Maximum des Elektrolumineszenzspektrums der organischen Elektrolumineszenzvorrichtung verstanden. Dem Fachmann der organischen Elektrolumineszenz ist bekannt, welcher Emitter welches Emissionsmaximum aufweist, und er kann daher geeignete Emitter auswählen, welche ein Emissionsmaximum von ≤ 570 nm aufweisen.

Die organische Elektrolumineszenzvorrichtung muss nicht notwendigerweise nur Schichten enthalten, welche aus organischen oder metallorganischen Materialien aufgebaut sind. So ist es auch möglich, dass Anode, Kathode und/oder eine oder mehrere Schichten anorganische Materialien enthalten oder ganz aus anorganischen Materialien aufgebaut sind.

In einer bevorzugten Ausführungsform der Erfindung ist das Emissionsmaximum der organischen Elektrolumineszenzvorrichtung ≤ 560 nm, besonders bevorzugt ≤ 550 nm, ganz besonders bevorzugt 5 540 nm.

Generell ist es aus wirtschaftlichen Gründen und wegen der Seltenheit der Metalle Iridium und Platin wünschenswert, den Anteil der phosphoreszierenden Verbindung in der Emissionsschicht so gering wie möglich zu wählen, so lange dies nicht mit einer deutlichen Verschlechterung der Eigenschaften der organischen Elektrolumineszenzvorrichtung einher geht. In einer weiteren bevorzugten Ausführungsform der Erfindung ist daher die Gesamtkonzentration aller phosphoreszierenden Verbindungen in der emittierenden Schicht ≤ 9 Vol.%, besonders bevorzugt ≤ 8 Vol.%, ganz besonders ≤ 7 Vol.%.

Weiterhin bevorzugt ist die Gesamtkonzentration aller phosphoreszierenden Verbindungen in der emittierenden Schicht ≥ 1 Vol.%, besonders bevorzugt ≥ 2 Vol.%, ganz besonders bevorzugt ≥ 3 Vol.%. Diese Bevorzugung ist damit zu begründen, dass bei einer Konzentration der phosphoreszierenden Verbindung von weniger als 1 Vol.% sich üblicherweise die Effizienz, die Lebensdauer und/oder das Roll-Off-Verhalten verschlechtern.

In einer weiteren bevorzugten Ausführungsform der Erfindung ist HOMO(EBL) - HOMO(EML) ≤ 0.35 eV, besonders bevorzugt ≤ 0.3 eV, ganz besonders bevorzugt ≤ 0.25 eV.

In nochmals einer weiteren bevorzugten Ausführungsform der Erfindung ist LUMO(EML) - LUMO(HBL) ≤ 0.35 eV, besonders bevorzugt ≤ 0.3 eV, ganz besonders bevorzugt ≤ 0.25 eV.

In nochmals einer weiteren bevorzugten Ausführungsform der Erfindung ist HOMO(EML), also das HOMO aller Matrixkomponenten in der Emissionsschicht ≥ -5.8 eV, besonders bevorzugt ≥ -5.7 eV, ganz besonders bevorzugt ≥ -5.6 eV, insbesondere ≥ -5.55 eV.

In nochmals einer weiteren bevorzugten Ausführungsform der Erfindung ist LUMO(EML), also das LUMO aller Matrixkomponenten in der Emissionsschicht ≤ -2.55 eV, besonders bevorzugt ≤ -2.6 eV.

Für den Emitter gelten relativ zu dem Matrixmaterial bzw. den Matrixmaterialien bevorzugt die folgenden Beziehungen: $HOMO \left(Emitter\right) - HOMO \left(EML\right) \leq 0.3 eV$ und/oder $LUMO \left(EML\right) - LUMO \left(Emitter\right) \leq 0.3 eV .$

Dabei ist HOMO(Emitter) bzw. LUMO(Emitter) jeweils das HOMO bzw. das LUMO des phosphoreszierenden Emitters.

In einer weiteren bevorzugten Ausführungsform der Erfindung ist zwischen der Emissionsschicht und der Kathode kein Metallkomplex vorhanden. Diese Bevorzugung wird durch die häufig geringe thermische Stabilität sowie hohe Hydrolyseempfindlichkeit der üblicherweise als Elektronentransportmaterial bzw. Lochblockiermaterial verwendeten Metallkomplexe begründet. Weiterhin ist Hydroxychinolin, wie es als Ligand beispielsweise in Alq₃ verwendet wird, mutagen, und es ist daher wünschenswert, derartige Komplexe zu vermeiden.

Die oben genannten bevorzugten Ausführungsformen können beliebig miteinander kombiniert werden. Besonders bevorzugt treten die oben genannten bevorzugten Ausführungsformen gleichzeitig auf.

Bevorzugt ist also eine organische Elektrolumineszenzvorrichtung mit einem Emissionsmaximum von ≤ 560 nm, welche in der Emissionsschicht eine Gesamtkonzentration aller phosphoreszierenden Verbindungen zwischen 1 und 9 Vol.% enthält und welche zwischen der Emissionsschicht und der Kathode keinen Metallkomplex enthält, dadurch gekennzeichnet, dass für die Schichten gilt:
a) $HOMO \left(EBL\right) - HOMO \left(EML\right) \leq 0.35 eV;$
b) $LUMO \left(EML\right) - LUMO \left(HBL\right) \leq 0.35 eV ;$
c) $HOMO aller Matrixmaterialien der EML \geq - 5.9 eV ;$ und
d) $LUMO \left(EML\right) \leq - 2.55 eV .$

Besonders bevorzugt ist eine organische Elektrolumineszenzvorrichtung mit einem Emissionsmaximum von ≤ 550 nm, welche in der Emissionsschicht eine Gesamtkonzentration aller phosphoreszierenden Verbindungen zwischen 2 und 8 Vol.% enthält und welche zwischen der Emissionsschicht und der Kathode keinen Metallkomplex enthält, dadurch gekennzeichnet, dass für die Schichten gilt:
a) $HOMO \left(EBL\right) - HOMO \left(EML\right) \leq 0.3 eV ;$
b) $LUMO \left(EML\right) - LUMO \left(HBL\right) \leq 0.3 eV ;$
c) $HOMO aller Matrixmaterialien der EML \geq - 5 ⁢ .8 eV ;$ und
d) $LUMO \left(EML\right) \leq - 2.6 eV .$

Ganz besonders bevorzugt ist also eine organische Elektrolumineszenzvorrichtung mit einem Emissionsmaximum von ≤ 540 nm, welche in der Emissionsschicht eine Gesamtkonzentration aller phosphoreszierenden Verbindungen zwischen 3 und 7 Vol.% enthält und welche zwischen der Emissionsschicht und der Kathode keinen Metallkomplex enthält, dadurch gekennzeichnet, dass für die Schichten gilt:
a) $HOMO \left(EBL\right) - HOMO \left(EML\right) \leq 0.25 eV ;$
b) $LUMO \left(EML\right) - LUMO \left(HBL\right) \leq 0.25 eV ;$
c) $HOMO aller Matrixmaterialien der EML \geq - 5.8 eV ;$ und
d) $LUMO \left(EML\right) \leq - 2.6 eV .$

Weiterhin gelten in der erfindungsgemäßen organischen Elektrolumineszenzvorrichtung bevorzugt die folgenden Bedingungen:
In einer bevorzugten Ausführungsform der Erfindung ist das HOMO(EBL) ≥ -5.5 eV, besonders bevorzugt ≥ -5.45 eV, ganz besonders bevorzugt ≥ -5.4 eV, insbesondere ≥ -5.35 eV. Insbesondere gilt für alle Materialien der EBL bevorzugt HOMO ≥ -5.5 eV, besonders bevorzugt ≥ -5.45 eV, ganz besonders bevorzugt ≥ -5.4 eV, insbesondere ≥ -5.35 eV.

In einer weiteren bevorzugten Ausführungsform der Erfindung ist das LUMO(HBL) ≤ -2.5 eV. Besonders bevorzugt gilt für alle Materialien der HBL LUMO ≤ -2.5 eV.

In einer weiteren bevorzugten Ausführungsform der Erfindung gilt für das Triplettniveau T₁(Emitter) - T₁(Matrix) ≤ 0.2 eV, besonders bevorzugt ≤ 0.15 eV, ganz besonders bevorzugt ≤ 0.1 eV. Dabei ist T₁ (Matrix) das Triplettniveau des Matrixmaterials in der Emissionsschicht, und T₁(Emiter) ist das Triplettniveau des phosphoreszierenden Emitters. Enthält die Emissionsschicht mehrere Matrixmaterialien, so gilt die oben genannte Beziehung bevorzugt für jedes der Matrixmaterialien.

In einer weiteren bevorzugten Ausführungsform der Erfindung ist das Triplettniveau T₁(Emitter) - T₁(EBL) ≤ 0.3 eV, besonders bevorzugt ≤ 0.25 eV, ganz besonders bevorzugt ≤ 0.2 eV. Dabei ist T₁(EBL) das Triplettniveau des Materials der Elektronenblockierschicht. Wenn die Elektronenblockierschicht aus mehreren Materialien besteht, so gilt diese Bedingung bevorzugt für alle Materialien der Elektronenblockierschicht.

In einer weiteren bevorzugten Ausführungsform der Erfindung ist das Triplettniveau T₁(Emitter) - T₁(HBL) ≤ 0.3 eV, besonders bevorzugt ≤ 0.25 eV, ganz besonders bevorzugt ≤ 0.2 eV. Dabei ist T₁(HBL) das Triplettniveau des Materials der Lochblockierschicht. Wenn die Lochblockierschicht aus mehreren Materialien besteht, so gilt diese Bedingung bevorzugt für alle Materialien der Lochblockierschicht.

In einer weiteren bevorzugten Ausführungsform der Erfindung enthält die Emissionsschicht genau eine phosphoreszierende Verbindung, insbesondere einen phosphoreszierenden Metallkomplex. Geeignete phosphoreszierende Metallkomplexe sind hinten genauer aufgeführt.

In einer bevorzugten Ausführungsform der Erfindung enthält die Emissionsschicht genau ein Matrixmaterial, für das die oben genannten Bedingungen für HOMO und LUMO gelten.

In einer weiteren bevorzugten Ausführungsform der Erfindung enthält die Emissionsschicht zwei oder mehr unterschiedliche Matrixmaterialien ("Mixed Matrix"), besonders bevorzugt zwei oder drei Matrixmaterialien.

Wenn zwei oder mehr Matrixmaterialien verwendet werden, beträgt die Konzentration der Komponente mit dem höchsten HOMO bevorzugt ≤ 50 Vol.%, besonders bevorzugt ≤ 45 Vol.%, ganz besonders bevorzugt ≤ 40 Vol.%, insbesondere ≤ 35 Vol.%.

Wenn zwei oder mehr Matrixmaterialien verwendet werden, beträgt die Konzentration der Komponente mit dem höchsten HOMO weiterhin bevorzugt ≥ 4 Vol.%, besonders bevorzugt ≥ 6 Vol.%, ganz besonders bevorzugt ≥ 8 Vol.%, insbesondere ≥ 10 Vol.%.

In einer weiteren bevorzugten Ausführungsform der Erfindung ist das Matrixmaterial mit dem höchsten HOMO nicht in der Elektronenblockierschicht enthalten.

Damit die Elektronenblockierschicht effizient Elektronen blockiert, gilt bevorzugt: LUMO(EBL) - LUMO(EML) ≥ 0.2 eV, besonders bevorzugt ≥ 0.25 eV, ganz besonders bevorzugt ≥ 0.3 eV, insbesondere ≥ 0.35 eV.

Damit die Lochblockierschicht effizient Löcher blockiert, gilt bevorzugt: HOMO(EML) - HOMO(HBL) ≥ 0.2 eV, besonders bevorzugt ≥ 0.25 eV, ganz besonders bevorzugt ≥ 0.3 eV, insbesondere ≥ 0.35 eV.

Die erfindungsgemäße organische Elektrolumineszenzvorrichtung kann außer der Elektronenblockierschicht, der Emissionsschicht und der Lochblockierschicht noch weitere Schichten aufweisen, beispielsweise Lochinjektions- und/oder -transportschichten, Elektroneninjektions- und/oder -transportschichten, Ladungserzeugungsschichten oder sonstige Zwischenschichten.

In einer bevorzugten Ausführungsfomr der Erfindung enthält die erfindungsgemäße organische Elektrolumineszenzvorrichtung genau eine Emissionsschicht.

In einer bevorzugten Ausführungsform der Erfindung enthält die organische Elektrolumineszenzvorrichtung mindestens eine Lochtransportschicht (HTL) zwischen der Anode und der Elektronenblockierschicht, wobei bevorzugt gilt: HOMO(HTL) - HOMO(EBL) ≤ 0.4 eV, besonders bevorzugt ≤ 0.35 eV, ganz besonders bevorzugt ≤ 0.3 eV, insbesondere ≤ 0.25 eV. Dabei ist HOMO(HTL) das HOMO der Lochtransportschicht. Besteht diese Schicht aus mehreren Materialien, so ist HOMO(HTL) das am höchsten liegende HOMO dieser Materialien.

In einer weiteren bevorzugten Ausführungsform der Erfindung enthält die organische Elektrolumineszenzvorrichtung mindestens eine Elektronentransportschicht (ETL) zwischen der Kathode und der Lochblockierschicht. Für die Elektronentransportschicht gilt bevorzugt für das LUMO der Schicht LUMO(ETL) ≤ -2.5 eV. Dabei ist LUMO(ETL) das LUMO der Elektronentransportschicht. Besteht diese Schicht aus mehreren Materialien, so ist LUMO(ETL) das betragsmäßig größte LUMO dieser Materialien, also das am tiefsten liegende LUMO.

In einer besonders bevorzugten Ausführungsform der Erfindung enthält die erfindungsgemäße organische Elektrolumineszenzvorrichtung sowohl mindestens eine Lochtransportschicht wie auch mindestens eine Elektronentransportschicht.

Die genaue Struktur der Materialien, die in der Elektronenblockierschicht, in der Emissionsschicht, in der Lochblockierschicht und in gegebenenfalls weiteren vorhandenen Schichten verwendet werden, sind von untergeordneter Bedeutung, so lange die Materialien die oben genannten Bedingungen bezüglich der physikalischen Parameter erfüllen. Generell können alle Materialien verwendet werden, wie sie üblicherweise in diesen Schichten verwendet werden, vorausgesetzt die Materialien sind so aufeinander abgestimmt, dass die oben genannten physikalischen Parameter erfühlt sind. Der Fachmann kann ohne Probleme die entsprechenden physikalischen Parameter bestimmen und geeignete Materialkombinationen auswählen.

Wenn zwei oder mehr Matrixmaterialien verwendet werden, ist die Komponente des Matrixmaterials mit dem höchsten HOMO bevorzugt ausgewählt aus der Gruppe bestehend aus Triarylaminderivaten, Carbazolderivaten, kondensierten Carbazolderivaten und Diaza- bzw. Tetraazasilolderivaten. Dabei wird unter einem Triarylamin-Derivat im Sinne dieser Anmeldung eine Verbindung verstanden, in der drei aromatische oder heteroaromatische Gruppen an einen Stickstoff gebunden sind. Dabei ist es auch möglich, dass die Verbindung mehr als eine Aminogruppe enthält oder dass die aromatischen Gruppen miteinander verbunden sind, beispielsweise durch Kohlenstoffbrücken oder direkte Bindungen. Unter einem Carbazolderivat im Sinne dieser Anmeldung wird ein Carbazol bzw. ein Azacarbazol verstanden, welches an den Stickstoff bevorzugt eine aromatische oder heteroaromatische Gruppe gebunden enthält und welches auch substituiert sein kann. Unter einem kondensierten Carbazol-derivat im Sinne dieser Erfindung wird ein Carbazol oder Azacarbazol verstanden, an welches noch mindestens ein weiterer aromatischer und/oder nicht-aromatischer Ring ankondensiert ist. So wird beispielsweise ein Indolocarbazol oder Indenocarbazol aufgespannt. Weiterhin ist es möglich, dass ein aromatischer bzw. heteroaromatischer Substituent am Stickstoff des Carbazols mit dem Carbazolgrundkörper durch eine Einfachbindung oder eine Brücke, beispielsweise eine Kohlenstoffbrücke, verbunden ist.

Bevorzugte Triarylamin-Derivate sind die Verbindungen der folgenden Formeln (1) bis (7), 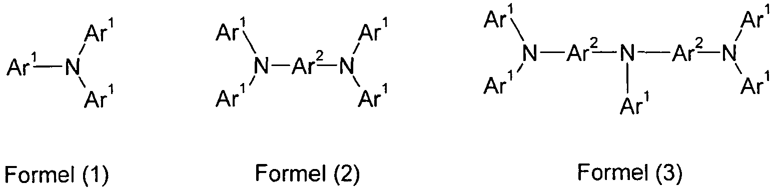 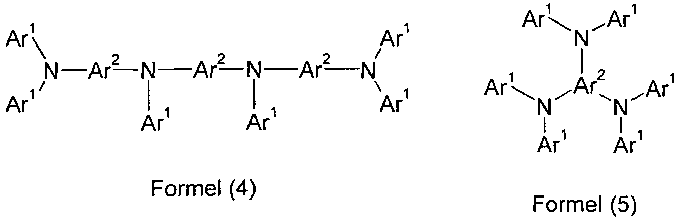 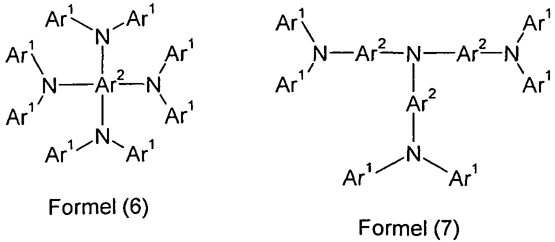 wobei für die verwendeten Symbole gilt:
- Ar¹: ist bei jedem Auftreten gleich oder verschieden ein monovalentes aromatisches oder heteroaromatisches Ringsystem mit 5 bis 60 aromatischen Ringatomen, welches durch einen oder mehrere Reste R¹ substituiert sein kann; dabei können zwei Gruppen Ar¹, welche an dasselbe Stickstoffatom binden, und/oder eine Gruppe Ar² mit einer Gruppe Ar¹, welche an dasselbe Stickstoffatom binden, miteinander durch eine Einfachbindung oder eine Brücke, ausgewählt aus der Gruppe bestehend aus B(R¹), C(R¹)₂, Si(R¹)₂, C=O, C=NR¹, C=C(R¹)₂, O, S, S=O, SO₂, N(R¹), P(R¹) und P(=O)R¹, verknüpft sein;
- Ar²: ist bei jedem Auftreten gleich oder verschieden ein bivalentes, trivalentes oder tetravalentes aromatisches oder heteroaromatisches Ringsystem mit 5 bis 60 aromatischen Ringatomen, welches durch einen oder mehrere Reste R¹ substituiert sein kann;
- R¹: ist bei jedem Auftreten gleich oder verschieden H, D, F, Cl, Br, I, CHO, C(=O)Ar³, P(=O)(Ar³)₂, S(=O)Ar³, S(=O)₂Ar³, CR²=CR²Ar³, CN, NO₂, Si(R²)₃, B(OR²)₂, B(R²)₂, B(N(R²)₂)₂, OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Kombination dieser Systeme; dabei können zwei oder mehrere benachbarte Substituenten R¹ auch miteinander ein mono- oder polycyclisches, aliphatisches oder aromatisches Ringsystem bilden;
- Ar³: ist bei jedem Auftreten gleich oder verschieden ein aromatisches oder heteroaromatisches Ringsystem mit 5 bis 40 aromatischen Ringatomen, das mit einem oder mehreren Resten R² substituiert sein kann;
- R²: ist bei jedem Auftreten gleich oder verschieden H, D oder ein aliphatischer, aromatischer und/oder heteroaromatischer Kohlenwasserstoffrest mit 1 bis 20 C-Atomen, in dem auch H-Atome durch D oder F ersetzt sein können; dabei können zwei oder mehrere benachbarte Substituenten R² auch miteinander ein mono- oder polycyclisches, aliphatisches oder aromatisches Ringsystem bilden.

Wenn zwei Gruppen Ar¹ oder eine Gruppe Ar² mit einer Gruppe Ar¹, welche jeweils an dasselbe Stickstoffatom binden, miteinander durch eine Einfachbindung verknüpft sind, entsteht dadurch ein Carbazol-Derivat.

Dabei ist Ar² in den Verbindungen der Formeln (2), (3), (4) und (7) eine bivalente Gruppe und in den Verbindungen der Formel (5) eine trivalente Gruppe und in den Verbindungen der Formel (6) eine tetravalente Gruppe.

Bevorzugte Carbazol-Derivate sind die Verbindungen der folgenden Formeln (8) bis (11), 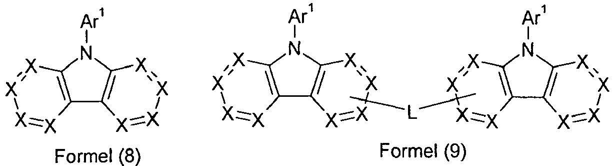 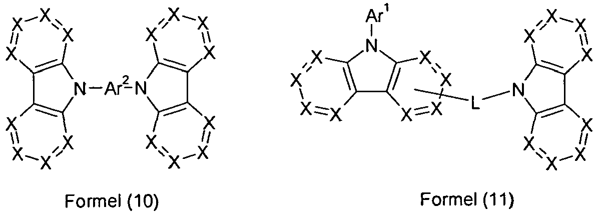 wobei Ar¹, Ar² und R¹ die oben genannten Bedeutungen haben und weiterhin gilt:
- L: ist eine Einfachbindung oder eine bivalente Gruppe, ausgewählt aus einer Alkylengruppe mit 1 bis 10 C-Atomen oder einer Alkenylen- oder Alkinylengruppe mit 2 bis 10 C-Atomen, die jeweils durch einen oder mehrere Reste R¹ substituiert sein kann, einem aromatischen oder heteroaromatischen Ringsystem mit 5 bis 30 aromatischen Ringatomen, welches jeweils durch einen oder mehrere Reste R¹ substituiert sein kann, C=O, O, S oder NR¹ oder einer Kombination aus 2, 3, 4 oder 5 dieser Gruppen;
- X: ist bei jedem Auftreten gleich oder verschieden CR¹ oder N, mit der Maßgabe, dass pro Cyclus maximal zwei Symbole X für N stehen und dass X für C steht, wenn an diese Gruppe X eine Gruppe L gebunden ist;
dabei können auch zwei benachbarte Gruppen X durch eine Gruppe der folgenden Formel (12) ersetzt sein: 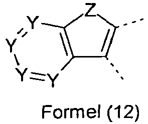 dabei deuten die gestrichelten Bindungen die Verknüpfung dieser Einheit mit dem Carbazolderivat an, d. h. die beiden Kohlenstoffatome, die in Formel (12) an die gestrichelten Bindungen anknüpfen entsprechen den beiden benachbarten Gruppen X des Carbazols; weiterhin gilt:
- Y: ist bei jedem Auftreten gleich oder verschieden CR¹ oder N, mit der Maßgabe, dass pro Cyclus maximal zwei Symbole Y für N stehen;
- Z: ist bei jedem Auftreten gleich oder verschieden ausgewählt aus der Gruppe bestehend aus C(R¹)₂, N(R¹), N(Ar¹), O, S, B(R¹), Si(R¹)₂, C=O, C=NR¹, C=C(R¹)₂, S=O, SO₂, CR¹-CR¹, P(R¹) und P(=O)R¹.

Dabei erfolgt die Verknüpfung der beiden Carbazolgruppen in Formel (9) bevorzugt über die 2,2'-, die 3,3' oder die 2,3'-Positionen, und die Verknüpfung der Carbazolgruppe in Formel (11) erfolgt bevorzugt über die 2- oder die 3-Position.

Weiterhin bevorzugte Materialien sind Verbindungen, welche sowohl mindestens eine Arylaminogruppe wie auch mindestens eine Carbazolgruppe bzw. mindestens ein Carbazol-Derivat aufweisen. Dies sind bevorzugt Verbindungen der folgenden Formeln (13), (14) und (15), 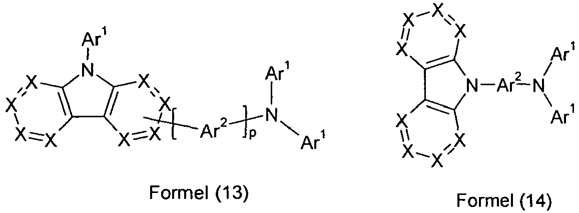 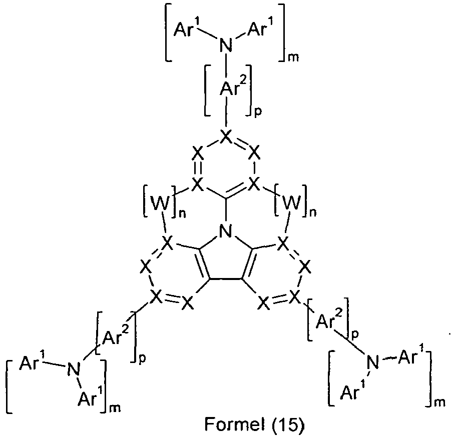 wobei die verwendeten Symbole die oben genannten Bedeutungen aufweisen und weiterhin gilt:
- W: ist gleich oder verschieden bei jedem Auftreten eine Einfachbindung, C(R¹)₂, NR¹, O oder S, wobei maximal eine Gruppe W für eine Einfachbindung steht;
- n: ist gleich oder verschieden bei jedem Auftreten 0 oder 1, wobei mindestens ein Index n für 1 steht;
- m: ist gleich oder verschieden bei jedem Auftreten 0 oder 1, wobei mindestens ein Index m für 1 steht;
- p: ist gleich oder verschieden bei jedem Auftreten 0, 1 oder 2;
weiterhin gilt, dass X für C steht, wenn an diese Gruppe X eine Gruppe N(Ar¹)₂ oder eine Gruppe Ar² oder eine Gruppe W gebunden ist.

Dabei erfolgt die Verknüpfung der Carbazolgruppe mit Ar² in Formel (13) bevorzugt über die 2- oder die 3-Position.

Nochmals weiterhin bevorzugt sind dimere überbrückte Carbazolderivate gemäß der folgenden Formel (16), 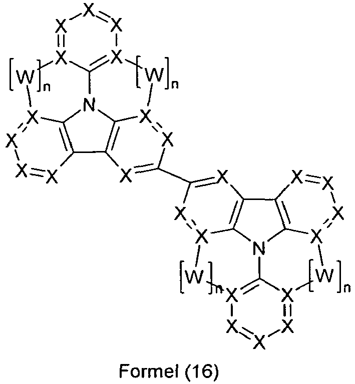 wobei die verwendeten Symbole und Indizes die oben genannten Bedeutungen aufweisen.

Eine Arylgruppe im Sinne dieser Erfindung enthält mindestens 6 C-Atome; eine Heteroarylgruppe im Sinne dieser Erfindung enthält mindestens 2 C-Atome und mindestens 1 Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Pyren, Chinolin, Isochinolin, etc., verstanden.

Ein aromatisches Ringsystem im Sinne dieser Erfindung enthält mindestens 6 C-Atome im Ringsystem. Ein heteroaromatisches Ringsystem im Sinne dieser Erfindung enthält mindestens 2 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nicht-aromatische Einheit (bevorzugt weniger als 10 % der von H verschiedenen Atome), wie z. B. ein C-, N-, O- oder S-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, Benzophenon, etc. als aromatische Ringsysteme im Sinne dieser Erfindung verstanden werden. Ebenso werden unter einem aromatischen bzw. heteroaromatischen Ringsystem Systeme verstanden, in denen mehrere Aryl- bzw. Heteroarylgruppen durch Einfachbindungen miteinander verknüpft sind, beispielsweise Biphenyl, Terphenyl oder Bipyridin.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl und 2,2,2-Trifluorethyl verstanden. Unter einer unter einer C₂- bis C₄₀-Alkenylgruppe werden bevorzugt Ethenyl, Propenyl, Butenyl, Pentenyl, Cyclopentenyl, Hexenyl, Cyclohexenyl, Heptenyl, Cycloheptenyl, Octenyl und Cyclooctenyl verstanden. Unter einer unter einer C₂-bis C₄₀-Alkinylgruppe werden bevorzugt Ethinyl, Propinyl, Butinyl, Pentinyl, Hexinyl, Heptinyl und Octinyl verstanden. Unter einer C₁- bis C₄₀-Alkoxygruppe werden besonders bevorzugt Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Benzanthracen, Benzphenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Benzofluoren, Dibenzofluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugte Gruppen Ar¹ sind ausgewählt aus der Gruppe bestehend aus Phenyl, 2-, 3- oder 4-Tolyl, 3- oder 4-o-Xylyl, 2- oder 4-m-Xylyl, 2-p-Xylyl, o-, m- oder p-tert-Butylphenyl, o-, m- oder p-Fluorphenyl, 2-, 3- oder 4-Biphenyl, 2-, 3- oder 4-o-Terphenyl, 2-, 3- oder 4-m-Terphenyl, 2-, 3- oder 4-p-Terphenyl, 2'-p-Terphenyl, 2'-, 4'- oder 5'-m-Terphenyl, 3'- oder4'-o-Terphenyl, p-, m,p-, o,p-, m,m-, o,m- oder o,o-Quaterphenyl, Quinquephenyl, Sexiphenyl, 1-, 2-, 3- oder 4-Fluorenyl, 2-, 3- oder 4-Spiro-9,9'-bifluorenyl, 1-, 2-, 3- oder 4-(9,10-Dihydro)phenanthrenyl, Indenocarbazol, Indolocarbazol, 2- oder 3-Thienyl oder 2-, 3- oder 4-Pyridyl und Kombinationen einer oder mehrerer dieser Gruppen. Dabei können diese Gruppen jeweils auch durch einen oder mehrere Reste R¹ substituiert sein.

Diese Substituenten eignen sich auch als Substituenten an Diazasilolen und Tetraazasilolen.

Bevorzugte Gruppen Ar² sind ausgewählt aus der Gruppe bestehend aus o-, m- oder p-Phenylen, 2,2'-, 3,3'- oder 4,4'-Biphenyl, 2,2"-, 3,3"- oder 4,4"-o-Terphenyl, 2,2"-, 3,3"- oder 4,4"-m-Terphenyl, 2,2"-, 3,3"- oder 4,4"-p-Terphenyl, p-, m,p-, o,p-, m,m-, o,m- oder o,o-Quaterphenyl, Quinquephenyl, Sexiphenyl, 2,7-Fluorenyl, 2,7- oder 2,2'-Spiro-9,9'-bifluorenyl oder 2,7-(9,10-Dihydro)phenanthrenyl, welche jeweils durch einen oder mehrere Reste R¹ substituiert sein können. Dabei ist R¹ bevorzugt Methyl oder Phenyl,
Die Gruppen Ar¹ und Ar² können durch einen oder mehrere Reste R¹ substituiert sein. Diese Reste R¹ sind bevorzugt gleich oder verschieden bei jedem Auftreten gewählt aus der Gruppe bestehend aus H, D, F, einer geradkettigen Alkylgruppe mit 1 bis 4 C-Atomen oder einer verzweigten oder cyclischen Alkylgruppe mit 3 bis 5 C-Atomen, die jeweils mit einem oder mehreren Resten R² substituiert sein kann, wobei ein oder mehrere H-Atome durch D oder F ersetzt sein können, oder einem aromatischen Ringsystem mit 6 bis 24 aromatischen Ringatomen, das durch einen oder mehrere Reste R² substituiert sein kann, oder eine Kombination dieser Systeme; dabei können zwei oder mehrere benachbarte Substituenten R¹ auch miteinander ein mono- oder polycyclisches, aliphatisches oder aromatisches Ringsystem bilden. Wenn die organische Elektrolumineszenzvorrichtung aus Lösung aufgebracht wird, sind auch geradkettige, verzweigte oder cyclische Alkylgruppen mit bis zu 10 C-Atomen als Substituenten R¹ bevorzugt. Die Reste R¹ sind besonders bevorzugt gleich oder verschieden bei jedem Auftreten gewählt aus der Gruppe bestehend aus H, D oder einem aromatischen Ringsystem mit 6 bis 24 aromatischen Ringatomen, das durch einen oder mehrere Reste R² substituiert sein kann, bevorzugt aber unsubstituiert ist.

Insbesondere wenn die Gruppe Ar¹ oder Ar² ein Fluoren oder ein entsprechendes kondensiertes Derivat enthält, wie zum Beispiel Fluoren, Indenofluoren oder Indenocarbazol, so steht der Rest R¹ an den jeweiligen Brücken C(R¹)₂ bevorzugt für eine Alkylgruppe mit 1 bis 10 C-Atomen oder ein aromatisches oder heteroaromatisches Ringsystem mit 5 bis 24 aromatischen Ringatomen. Dabei ist R¹ besonders bevorzugt Methyl oder Phenyl.

Weitere geeignete Verbindungen sind Diazasilol- und Tetraazasilolderivate, insbesondere mit aromatischen Substituenten, wie beispielsweise in der WO 2010/054729 beschrieben. Geeignete Substituenten an den Diaza- und Tetraazasilolderivaten sind aromatische und heteroaromatische Ringsysteme, insbesondere auch solche, welche mit zwei Stickstoffatomen des Diaza- und Tetraazasilols verknüpft sind, oder auch Alkylgruppen.

Geeignete Matrixmaterialien mit hohem HOMO sind weiterhin z. B. die in WO 2005/039246, US 2005/0069729, JP 2004/288381, EP 1205527 oder WO 2008/086851 offenbarten Carbazolderivate, Indolocarbazolderivate, z. B. gemäß WO 2007/063754 oder WO 2008/056746, Azacarbazolderivate, z. B. gemäß EP 1617710, EP 1617711, EP 1731584, JP 2005/347160, bipolare Matrixmaterialien, z. B. gemäß WO 2007/137725, Indenocarbazolderivate, z. B. gemäß WO 2010/136109 und WO 2011/000455, verbrückte Triarylaminderivate, z. B. gemäß WO 2007/031165, WO 2011/042107 oder WO 2011/060867, oder Benzofuranyldibenzofuran-Derivate gemäß WO 2009/148015.

Beispiele für geeignete Materialien, wie sie als Matrixkomponente mit hohem HOMO in der Emissionsschicht eingesetzt werden können, sofern die oben genannten Bedingungen für das HOMO in Bezug auf die Elektronenblockierschicht eingehalten werden, sind die im Folgenden aufgeführten Strukturen.

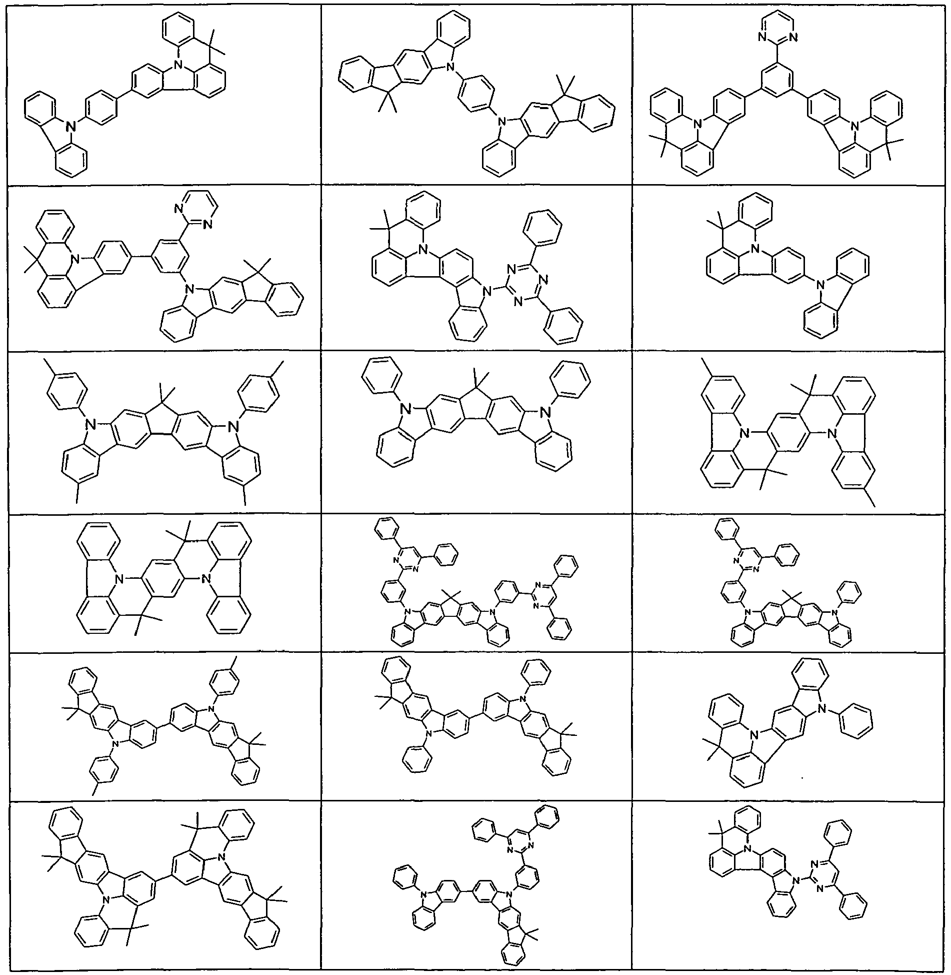

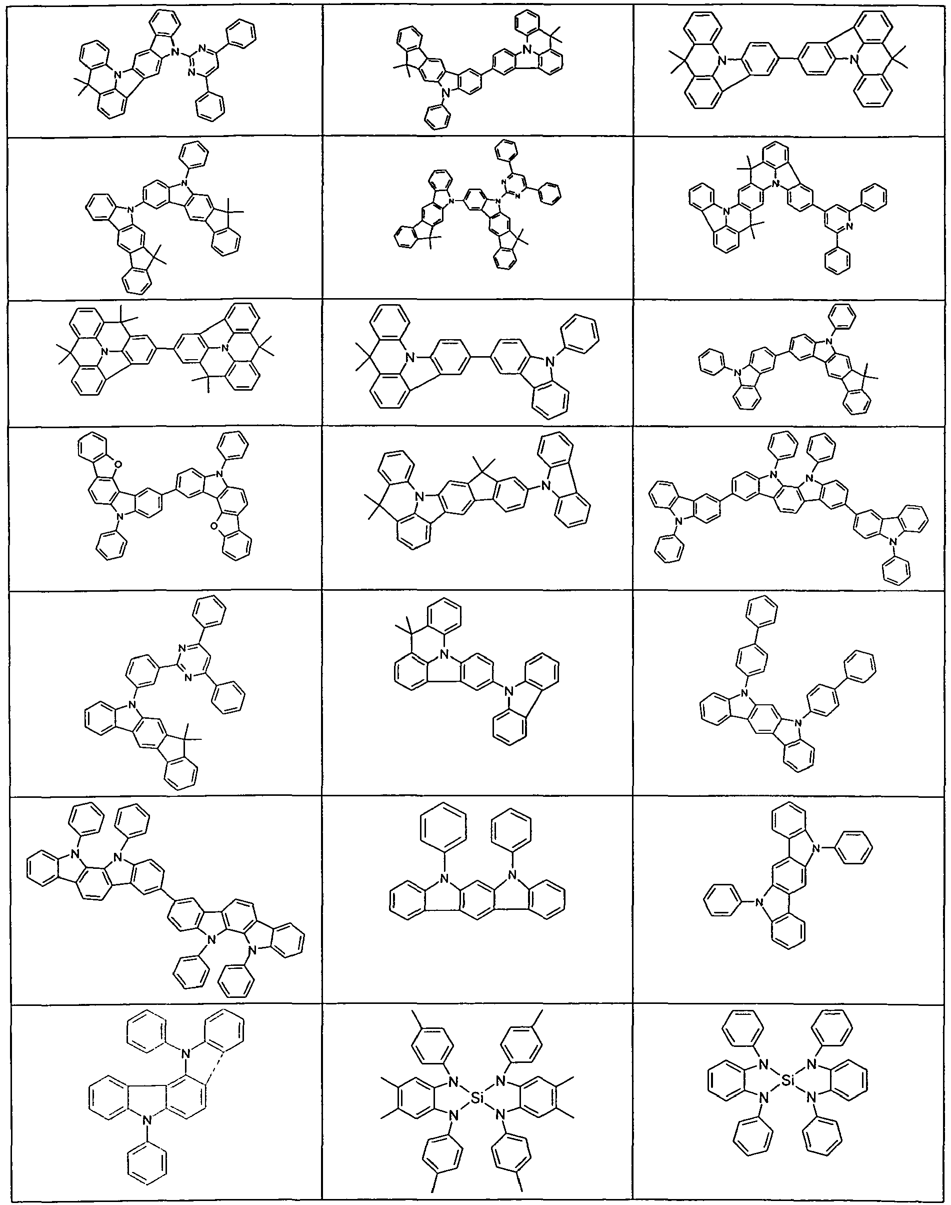

Geeignete Matrixmaterialien mit tiefem LUMO, welche in der Emissionsschicht verwendet werden können, sind beispielsweise ausgewählt aus der Gruppe bestehend aus aromatischen Ketonen, aromatischen Phosphinoxide, oder aromatischen Sulfoxiden oder Sulfonen, z. B. gemäß WO 2004/013080, WO 2004/093207, WO 2006/005627 oder WO 2010/006680, bipolaren Matrixmaterialien, z. B. gemäß WO 2007/137725, Silanen, z. B. gemäß WO 2005/111172, Azaborolen oder Boronestern, z. B. gemäß WO 2006/117052, Triazinderivaten, z. B. gemäß WO 2007/063754, WO 2008/056746, WO 2010/015306, WO 2011/057706 oder WO 2011/060877, Pyrimidinderivaten, z. B. gemäß der nicht offen gelegten Anmeldung EP 10014930.1, Diazaphosphol-Derivaten, z. B. gemäß WO 2010/054730, Indolocarbazolderivate, die mit elektronenarmen Heteroaromaten wie z. B. Triazin oder Pyrimidin substituiert sind, z. B. gemäß WO 2007/063754 oder WO 2008/056746, oder Indenocarbazolderivate, die mit elektronenarmen Heteroaromaten wie z. B. Triazin oder Pyrimidin substituiert sind, z. B. gemäß WO 2010/136109 und WO 2011/000455.

Beispiele für Matrixmaterialien mit tiefem LUMO sind die in der folgenden Tabelle aufgeführten Materialien.

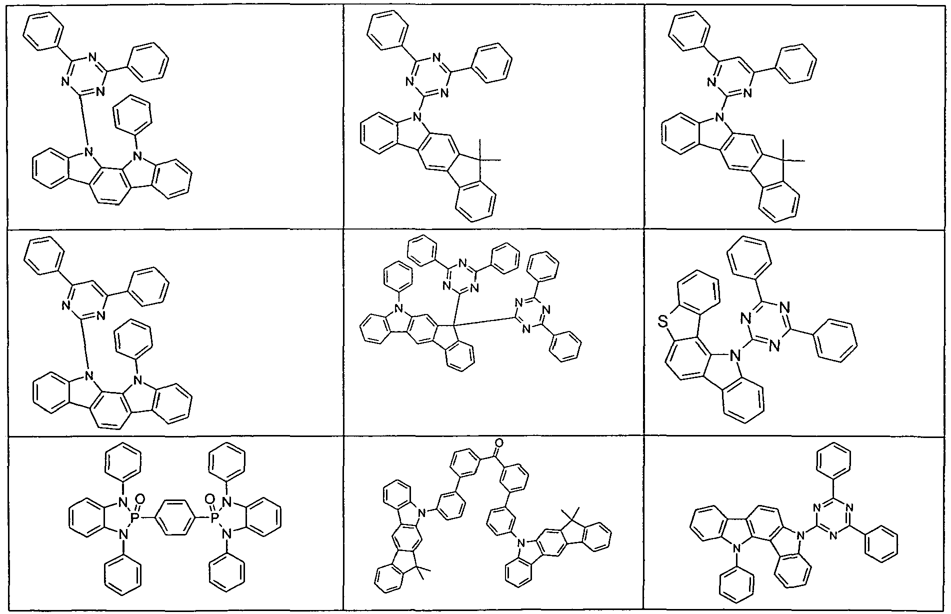

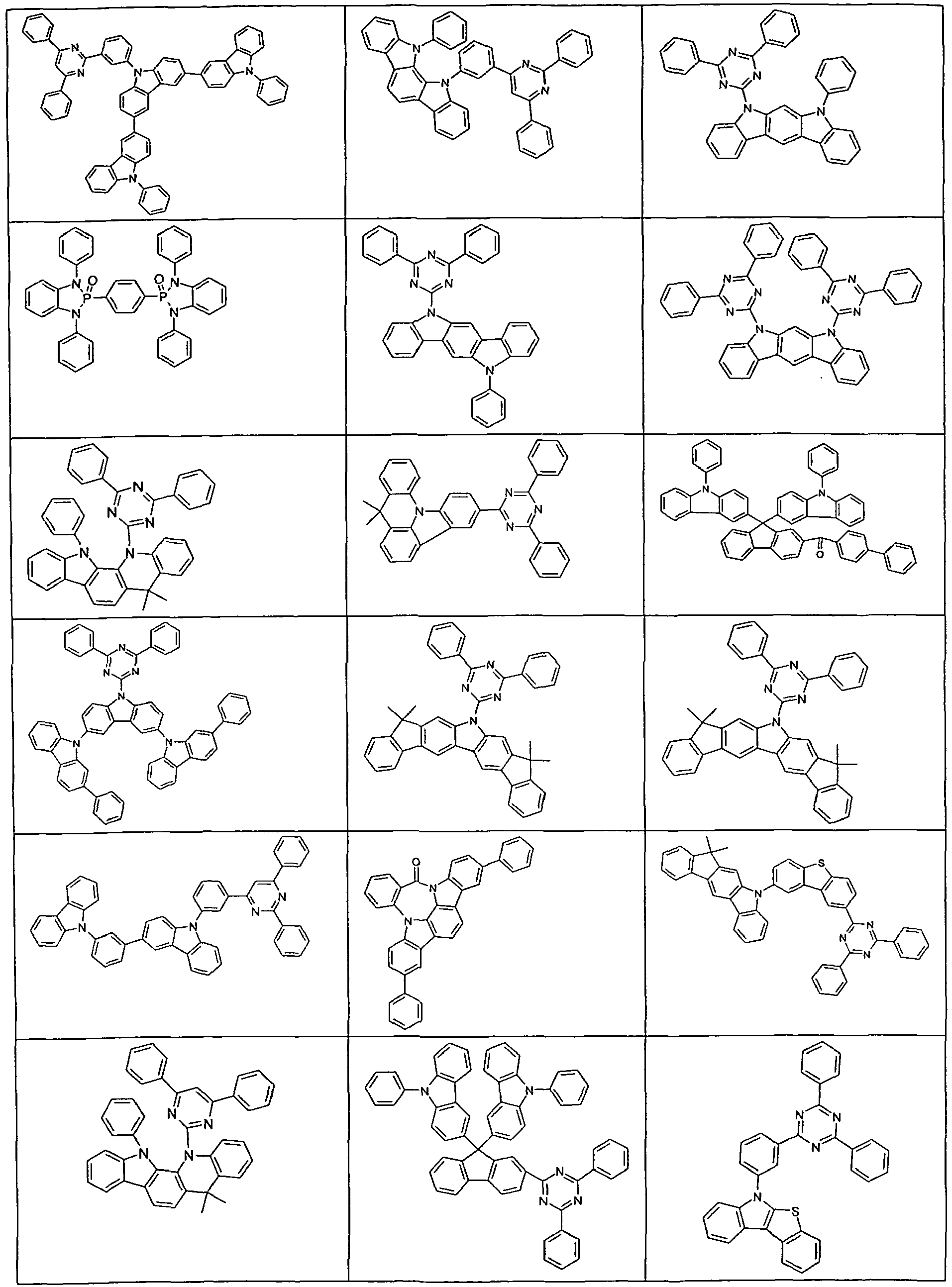

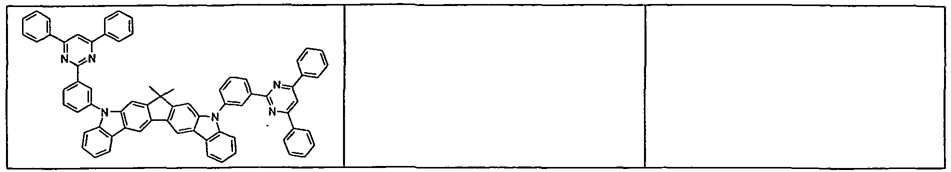

Wenn nur ein einzelnes Material als Matrixmaterial verwendet wird, so weist dieses Material sowohl die oben genannten Bedingungen für das HOMO wie auch für das LUMO auf. Geeignete Verbindungen sind beispielsweise bipolare Matrixmaterialien mit Ketogruppen bzw. mit Triazingruppen bzw. mit Pyrimidingruppen und gleichzeitig Arylamin- bzw. Carbazolgruppen, z. B. gemäß WO 2007/137725.

Als phosphoreszierende Verbindung in der Emissionsschicht eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten.

Besonders bevorzugte organische Elektrolumineszenzvorrichtungen enthalten als phosphoreszierende Verbindung mindestens eine Verbindung der Formeln (17) bis (20), 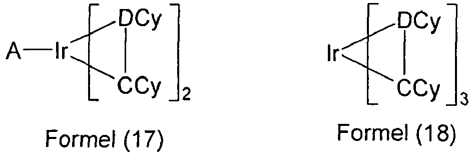 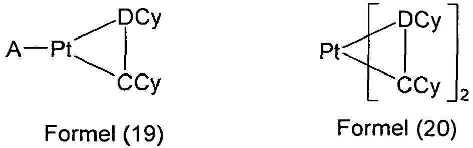 wobei R¹ dieselbe Bedeutung hat, wie oben für Formel (1) beschrieben, und für die weiteren verwendeten Symbole gilt:
- DCy: ist gleich oder verschieden bei jedem Auftreten eine cyclische Gruppe, die mindestens ein Donoratom, bevorzugt Stickstoff, Kohlenstoff in Form eines Carbens oder Phosphor, enthält, über welches die cyclische Gruppe an das Metall gebunden ist, und die wiederum einen oder mehrere Substituenten R¹ tragen kann; die Gruppen DCy und CCy sind über eine kovalente Bindung miteinander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹ tragen kann;
- A: ist gleich oder verschieden bei jedem Auftreten ein monoanionischer, zweizähnig chelatisierender Ligand, bevorzugt ein Diketonatligand.

Dabei kann durch Bildung von Ringsystemen zwischen mehreren Resten R¹ auch eine Brücke zwischen den Gruppen DCy und CCy vorliegen. Weiterhin kann durch Bildung von Ringsystemen zwischen mehreren Resten R¹ auch eine Brücke zwischen zwei oder drei Liganden CCy-DCy bzw. zwischen ein oder zwei Liganden CCy-DCy und dem Liganden A vorliegen, so dass es sich um ein polydentates bzw. polypodales Ligandensystem handelt.

Dabei werden die Metallkomplexe derart ausgewählt, dass sie bei Verwendung in der Emissionsschicht der organischen Elektrolumineszenzvorrichtung zum oben genannten Emissionsmaximum führen.

Beispiele der oben beschriebenen Emitter können den Anmeldungen WO 00/70655, WO 01/41512, WO 02/02714, WO 02/15645, EP 1191613, EP 1191612, EP 1191614, WO 04/081017, WO 05/033244, WO 05/042550, WO 05/113563, WO 06/008069, WO 06/061182, WO 06/081973, WO 2009/146770, WO 2010/031485, WO 2010/086089, WO 2010/099852, WO 2011/032626 und der nicht offen gelegten Anmeldung EP 10006208.2 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Verbindungen verwenden. Insbesondere ist dem Fachmann bekannt, welche phosphoreszierenden Komplexe mit welcher Emissionsfarbe emittieren, und er kann entsprechend Komplexe auswählen, welche ein Emissionsmaximum von ≤ 570 nm aufweisen bzw. die in einer organischen Elektrolumineszenzvorrichtung zu einem solchen Emissionsmaximum führen.

Als Kathode der erfindungsgemäßen Elektrolumineszenzvorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Ebenso bevorzugt sind Metalllegierungen, insbesondere Legierungen aus einem Alkalimetall oder Erdalkalimetall und Silber, besonders bevorzugt eine Legierung aus Mg und Ag. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, CsF, Cs₂CO₃, BaF₂, MgO, NaF, etc.). Ebenso kommen organische Alkali- oder Erdalkalikomplexe in Frage, wie z. B. Lithiumchinolinat (LiQ). Die Schichtdicke dieser Schicht beträgt bevorzugt zwischen 0.5 und 5 nm.

Als Anode der erfindungsgemäßen Elektrolumineszenzvorrichtung sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Dabei muss mindestens eine der Elektroden transparent oder teiltransparent sein, um die Auskopplung von Licht zu ermöglichen. Bevorzugte transparente oder teiltransparente Anodenmaterialien sind leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Es können generell alle weiteren Materialien, wie sie gemäß dem Stand der Technik in organischen Elektrolumineszenzvorrichtungen eingesetzt werden, auch in Kombination mit der erfindungsgemäßen Exzitonenblockier-, Emitter- und Lochblockierschicht eingesetzt werden.

Die Schichten der organischen Elektrolumineszenzvorrichtung können nach verschiedenen Methoden gemäß dem Stand der Technik aufgebracht werden.

Bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es sei jedoch angemerkt, dass der Druck auch noch geringer sein kann, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle-Printing, hergestellt werden. Hierfür sind lösliche Verbindungen nötig. Hohe Löslichkeit lässt sich durch geeignete Substitution der Verbindungen erreichen. Dabei können nicht nur Lösungen aus einzelnen Materialien aufgebracht werden, sondern auch Lösungen, die mehrere Verbindungen enthalten, beispielsweise Matrixmaterialien und Dotanden.

Die organische Elektrolumineszenzvorrichtung kann auch hergestellt werden, indem eine oder mehrere Schichten aus Lösung aufgebracht werden und eine oder mehrere andere Schichten aufgedampft werden.

Da mehrere Schichten übereinander aufgebracht werden, ist es bevorzugt, wenn die Emissionsschicht und die Lochblockierschicht und gegebenenfalls vorhandene Elektronentransportschichten aufgedampft sind. Besonders bevorzugt ist es, wenn die Elektronenblockierschicht, die Emissionsschicht und die Lochblockierschicht und gegebenenfalls vorhandene Elektronentransportschichten aufgedampft sind. Ganz besonders bevorzugt ist es, wenn alle organischen Schichten aufgedampft sind.

Diese Verfahren sind dem Fachmann generell bekannt und können von ihm ohne erfinderisches Zutun auf die erfindungsgemäßen organischen Elektrolumineszenzvorrichtungen angewandt werden.

Die erfindungsgemäße organische Elektrolumineszenzvorrichtung weist einen oder mehrere der folgenden überraschenden Vorteile gegenüber dem Stand der Technik auf:
1. Trotz der Verwendung einer geringen Konzentration des phosphoreszierenden Emitters von weniger als 10 Vol.% weist die erfindungsgemäße organische Elektrolumineszenzvorrichtung eine hohe Effizienz und eine hohe Lebensdauer auf.
2. Die erfindungsgemäße organische Elektrolumineszenzvorrichtung weist trotz der geringen Konzentration des phosphoreszierenden Emitters ein gutes Roll-Off-Verhalten auf, also nur eine geringe Abnahme der Effizienz bei hoher Leuchtdichte.
3. Die Eigenschaften der erfindungsgemäßen organischen Elektrolumineszenzvorrichtung weisen nur eine geringe Abhängigkeit von der genauen Konzentration des phosphoreszierenden Emitters auf. Dies führt zu einer höheren Prozesssicherheit in der Massenproduktion, da Schwankungen in der Aufdampfrate der einzelnen Verbindungen nicht zu wesentlichen Veränderungen der Eigenschaften führen.
4. Die Eigenschaften der erfindungsgemäßen organischen Elektrolumineszenzvorrichtung hängen nicht wesentlich von der Lage des HOMO und/oder LUMO des phosphoreszierenden Emitters ab. Damit werden nicht nur bei der Verwendung von Iridiumkomplexen als phosphoreszierende Emitter, sondern auch bei der Verwendung von grün emittierenden Platinkomplexen, die häufig ein tieferes HOMO aufweisen, gute Ergebnisse erzielt.

Die erfindungsgemäße organische Elektrolumineszenzvorrichtung kann für verschiedene Anwendungen verwendet werden, beispielsweise für ein- oder mehrfarbige Displays, für Beleuchtungsanwendungen, für medizinische Anwendungen, beispielsweise in der Phototherapie, oder für organische Laser (O-Laser).

Die Erfindung wird durch die nachfolgenden Beispiele genauer beschrieben, ohne sie dadurch einschränken zu wollen. Der Fachmann kann, ohne erfinderisch tätig zu werden, die Erfindung im gesamten offenbarten Bereich ausführen und so weitere erfindungsgemäße organische Elektrolumineszenzvorrichtungen herstellen.

### Beispiele:

### Herstellung der OLEDs

Die Herstellung der OLEDs erfolgt nach einem allgemeinen Verfahren gemäß WO 2004/058911, das auf die hier beschriebenen Gegebenheiten (Schichtdickenvariation, Materialien) angepasst wird.

In den folgenden Beispielen N1-E20 (siehe Tabellen 1 und 2) werden die Daten verschiedener OLEDs vorgestellt. Glasplättchen, die mit strukturiertem ITO (Indium Zinn Oxid) der Dicke 150 nm beschichtet sind, werden zur verbesserten Prozessierung mit 20 nm PEDOT beschichtet (Poly(3,4-ethylendioxy-2,5-thiophen), aus Wasser aufgeschleudert; bezogen von H. C. Starck, Goslar, Deutschland). Diese beschichteten Glasplättchen bilden die Substrate, auf welche die OLEDs aufgebracht werden. Die OLEDs haben prinzipiell folgenden Schichtaufbau: Substrat / optionale Lochinjektionsschicht (HIL) / Lochtransportschicht (HTL) / optionale Zwischenschicht (IL) / Elektronenblockierschicht (EBL) / Emissionsschicht (EML) / Lochblockierschicht (HBL) / optionale Elektronentransportschicht (ETL) / optionale Elektroneninjektionsschicht (EIL) und abschließend eine Kathode. Die Kathode wird durch eine 100 nm dicke Aluminiumschicht gebildet. Die zur Herstellung der OLEDs benötigten Materialien sind in Tabelle 4 abgebildet.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird.

Eine Angabe wie ST1:LiQ (55%:45%) bedeutet, dass das Material ST1 in einem Volumenanteil von 55% und LiQ in einem Anteil von 45% in der Schicht vorliegt.

In Tabelle 1 ist der Aufbau der verschiedenen OLEDs gezeigt. Die Emissionsschicht (EML) besteht jeweils aus einem Emitter und einem oder zwei Matrixmaterialien MM1 und MM2. Eine Angabe wie IC1:TEG1 bedeutet, dass nur ein Matrixmaterial vorhanden ist, in diesem Fall ist MM1=IC1, der Emitter ist das Material TEG1. Eine Angabe wie IC2:IC3:TEG2 bedeutet, dass zwei Matrixmaterialien vorhanden sind, in diesem Fall gilt MM1=IC2, MM2=IC3, der Emitter ist das Material TEG2. Da für die vorliegende Erfindung die Abhängigkeit der Leistungsdaten von der Konzentration des Emitters entscheidend ist, wird die Emitterkonzentration wie im Folgenden beschrieben variiert.

In Tabelle 2 sind die Daten der OLEDs für verschiedene Emitterkonzentrationen zusammengefasst. Die Beispiele N1-N10 sind Vergleichsbeispiele, die die erfindungsgemäßen Bedingungen nicht erfüllen. Die Beispiele E1-E10 zeigen erfindungsgemäße OLEDs. Sind zwei Matrixmaterialien vorhanden, ist in der Spalte "MM1:MM2" das Verhältnis der Volumenkonzentrationen dieser beiden Matrixmaterialien angegeben. Die Spalte "Konz. Emitter" bezeichnet die Volumenkonzentration des Emitters, wobei sich alle Volumenkonzentrationen zu 100% addieren. Die Angabe MM1:MM2=2:1 und Konz. Emitter=10% beudeutet z.B., dass MM1 in einem Volumenanteil von 60%, MM2 in einem Anteil von 30% und der Emitter in einem Anteil von 10% in der Emissionsschicht vorliegt. Bei nur einem Matrixmaterial ist die Spalte "MM1:MM2" leer, der Volumenanteil der Matrix beträgt dann 100% minus die Konzentration des Emitters.

Die Angaben "Rel. EQE", "Rel. Roll-Off" und "Rel. LD" zeigen, wie sich die Parameter EQE, Roll-Off und Lebensdauer (LD) mit der Emitterkonzentration ändern. Es handelt sich um relative Angaben für einen bestimmten Aufbau, bei dem nur die Emitterkonzentration variiert wird. Dabei ist EQE die externe Quanteneffizienz bei 1000 cd/m². Der Roll-Off ist definiert als EQE(5000 cd/m²)/EQE(1000 cd/m²). Ein hoher Roll-Off ist erwünscht, da in diesem Fall die Effizienz bei hohen Leuchtdichten hoch ist. Die Lebensdauer ist definiert als die Zeit, nach der die Leuchtdichte bei Betrieb mit konstantem Strom von einer Starthelligkeit von 4000 cd/m² auf 3200 cd/m² abfällt. Daten, die zu einem Aufbau gehören, sind in Tabelle 2 durch horizontale Doppelstriche eingeschlossen.

Weiterhin sind in Tabelle 3 relative Vergleiche zwischen verschiedenen Aufbauten gezeigt. Diese Vergleiche werden ebenfalls durch horizontale Doppelstriche eingeschlossen. Bei diesen Vergleichen sind jeweils diejenigen Konzentrationsverhältnisse verglichen, für die die Lebensdauer optimal ist.

Bei Mixed-Matrix Systemen wird für einen gegebenen Aufbau eine Optimierung des Mischungsverhältnisses der beiden Matrixkomponenten bei einer Emitterkonzentration von 10% vorgenommen. Für die Variation der Emitterkonzentration wird dasjenige Mischungsverhältnis gewählt, mit dem die höchste Lebensdauer erzielt wird, für Aufbau E1 also z. B. 2:1.

### Bestimmung der HOMO/LUMO Lagen und des Triplett-Niveaus

Die HOMO- und LUMO-Lagen sowie das Triplettniveau der Materialien werden über quantenchemische Rechnungen bestimmt. Hierzu wird das Programmpaket "Gaussian03W" (Gaussian Inc.) verwendet. Zur Berechnung organischer Substanzen ohne Metalle (in Tabelle 5 mit Methode "org." bezeichnet) wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31 G(d)" verwendet (Charge 0, Spin Singlet). Für metallorganische Verbindungen (in Tabelle 5 mit Methode "M-org." bezeichnet) wird die Geometrie über die Methode "Ground State/ Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31 G(d)" verwendet wird. Aus der Energierechnung erhält man das HOMO HEh bzw. LUMO LEh in Hartree-Einheiten. Daraus werden die anhand von Cyclovoltammetriemessungen kalibrierten HOMO und LUMO Werte in Elektronenvolt wie folgt bestimmt: $HOMO \left(eV\right) = \left(\left(HEh*27.212\right)-0.9899\right) / 1.1206$ $LUMO \left(eV\right) = \left(\left(LEh*27.212\right)-2.0041\right) / 1.385$

Diese Werte sind im Sinne dieser Anmeldung als HOMO bzw. LUMO der Materialien anzusehen. Als Beispiel erhält man für die Substanz BPA1 aus der Rechnung ein HOMO von -0.17519 Hartrees und ein LUMO von -0.04192 Hartrees, was einem kalibrierten HOMO von -5.14 eV und einem kalibrierten LUMO von -2.27 eV entspricht.

Das Triplettniveau T₁ ist definiert als die Energie des Triplettzustands mit der niedrigsten Energie, der sich aus der quantenchemischen Rechnung ergibt.

In Tabelle 5 sind die HOMO- und LUMO-Werte sowie die Triplettniveaus T₁ der verschiedenen Materialien angegeben.

### Erläuterungen der Beispiele

Im Folgenden werden einige der Beispiele näher erläutert, um die Vorteile der erfindungsgemäßen OLEDs zu verdeutlichen. Es sei jedoch darauf hingewiesen, dass dies nur eine Auswahl der in Tabelle 2 gezeigten Daten darstellt. Die Beispiele N1-N8 und E1-E20_{E10} zeigen grüne Emission, das Maximum der Emission liegt zwischen 519 und 527 nm. Für die OLEDs der Beispiele N9 und N10 liegt das Maximum der Emission zwischen 485 und 489 nm.

### Bedeutung der HOMO-Differenz zwischen EBL und EML

Für die Beispiele N1 (HOMO(EBL) - HOMO(EML) = 0.65 eV), N2, N3 (HOMO(EBL) - HOMO(EML) = 0.48 eV) und N4 (HOMO(EBL) - HOMO(EML) = 0.42 eV) ist die Bedingung HOMO(EBL) - HOMO(EML) < 0.4 eV nicht erfüllt. Dementsprechend verschlechtern sich Effizienz und/oder Roll-Off und/oder Lebensdauer, wenn man eine Emitterkonzentration < 10 Vol.% einsetzt. Dies gilt sowohl bei Einsatz einer Einzelmatrix (Beispiele N1, N2, N3) sowie für Mixed-Matrix Systeme (Beispiel N4). Hingegen zeigen OLEDs, für welche die HOMO Differenz unter 0.4 eV liegt (Beispiele E1-E10) fast in allen Fällen ein Optimum bezüglich Effizienz, Roll-Off und Lebensdauer bei Emitterkonzentration < 10 Vol.%.

Ist dies nicht der Fall, so ist die Verbesserung bei Emitterkonzentrationen von ≥ 10% gegenüber dem Optimum nur unbedeutend. Nur bei einer sehr geringen Emitterkonzentrationen von 1 Vol.% in Beispiel E1 erhält man eine deutliche Verschlechterung der Lebensdauer.

### Bedeutung von LUMO(EML)

Für die Beispiele N5 (LUMO(EML) = -2.50 eV), N6 (LUMO(EML) = -2.42 eV) und N8 (LUMO(EML) = -2.14 eV) gilt die Bedingung LUMO(EML) < -2.5 eV nicht. Im Gegensatz zu erfindungsgemäßen OLEDs erhält man in diesem Fall eine Verschlechterung der Leistungsdaten, insbesondere der Lebensdauer, bei Emitterkonzentrationen unter 10 Vol.%. Im Falle des Mixed-Matrix Systems (Beispiel N6) ist die Verschlechterung nicht ganz so deutlich wie im Falle der Einzelmatrix, aber immer noch signifikant. Besonders deutlich ist die Verschlechterung in Beispiel N8 (LUMO(EML) - LUMO(HBL) = 0.69 eV), wo neben der Bedingung LUMO(EML) < -2.5 eV auch die Bedingung LUMO(EML) - LUMO(HBL) < 0.4 eV nicht erfüllt ist.

### Bedeutung der HOMO-Lagen der Matrixmaterialien

Liegt für ein Matrixmaterial das HOMO unter -6.0 eV, so erhält man ebenfalls eine Verschlechterung der Leistungsdaten für Emitterkonzentrationen unter 10 Vol.% (Beispiel N7). Dies ist wie oben beschrieben für erfindungsgemäße OLEDs nicht der Fall.

### Verwendung eines Aluminiummetallkomplexes in der Elektronentransportschicht

Beispiel N9 zeigt, dass man bei Verwendung von Alq₃ in der ETL in Kombination mit dem Lochblocker Ket1 mit einer Emitterkonzentrationen von 5 Vol.% die optimale Effizienz erhält; der Roll-Off ändert sich mit der Emitterkonzentration nicht signifikant. Allerdings erhält man eine nicht akzeptable Verschlechterung der Lebensdauer für Emitterkonzentrationen < 10 Vol.%. Ohne Lochblockierschicht erhält man bei Emitterkonzentrationen < 10 Vol.% zusätzlich eine Verschlechterung von Effizienz und Roll-Off (Beispiel N10). In Beispiel E7 mit ähnlichem Aufbau und Materialien ist dies nicht der Fall.

### Verbesserungen durch geringe HOMO- bzw. LUMO-Differenzen aller Matrixmaterialien

Insbesondere erhält man sehr gute Leistungsdaten, wenn für beide Matrixkomponenten MM1 und MM2 in einem Mixed-Matrix System die Bedingungen HOMO(EBL) - HOMO(MM1, MM2) < 0.4 eV bzw. LUMO(MM1, MM2) - LUMO(HBL) < 0.4 eV erfüllt sind. Dies ist anhand der Beispiele E9 (HOMO(EBL) - HOMO(MM1) = 0.34 eV; HOMO(EBL) - HOMO(MM2) = 0.25 eV) und E10 (LUMO(MM1) - LUMO(HBL) = 0.04 eV; LUMO(MM2) - LUMO(HBL) = 0.09 eV) gezeigt: Im mit E9 vergleichbaren Aufbau E1, für den HOMO(EBL) - HOMO(MM1) = 0.67 eV gilt, erhält man vergleichbare Effizienz und Roll-Off, aber eine verringerte Lebensdauer. Im mit E10 vergleichbaren Aufbau E3, für den LUMO(MM2) - LUMO(HBL) = 0.65 eV gilt, erhält man eine schlechtere Effizienz und Lebensdauer (siehe Tabelle 3) der OLEDs

**Tabelle 1: Aufbau der OLEDs**

| Bsp. | HIL Dicke | HTL Dicke | IL Dicke | EBL Dicke | EML Dicke | HBL Dicke | ETL Dicke | EIL Dicke |
|---|---|---|---|---|---|---|---|---|
| N1 | --- | SpA1 | HATCN | BPA1 | IC1:TEG1 | --- | ST1:LiQ (50%:50%) | --- |
| | | 70nm | 5nm | 90nm | 30nm | | 40nm | |
| N2 | --- | SpA1 | HATCN | BPA1 | IC2:TEG1 | --- | ST1 | LiQ |
| | | 70nm | 5nm | 90nm | 30nm | | 40nm | 3nm |
| N3 | --- | SpA1 | HATCN | BPA1 | IC2:TEG3 | --- | ST1:LiQ (50%:50%) | --- |
| | | 70nm | 5nm | 130nm | 30nm | | 40nm | |
| N4 | --- | SpA1 | --- | ICA1 | IC2:IC3:TEG2 | IC2 | ST2:LiQ (50%:50%) | --- |
| | | 200nm | | 20nm | 40nm | 5nm | 25nm | |
| N5 | --- | SpA1 | HATCN | SPA2 | DAP1:TEG1 | --- | ST1:LiQ (50%:50%) | --- |
| | | 70nm | 5nm | 90nm | 30nm | | 40nm | |
| N6 | --- | SpA1 | HATCN | SPA2 | IC6:Cbz1 :TEG1 | IC1 | ST1:LiQ (50%:50%) | --- |
| | | 70nm | 5nm | 90nm | 30nm | 10nm | 30nm | |
| N7 | --- | SpA1 | HATCN | BPA1 | ST1:Cbz2:TEG1 | --- | ST2:LiQ (50%:50%) | --- |
| | | 110nm | 10nm | 100nm | 40nm | | 30nm | |
| N8 | --- | SpA1 | HATCN | CbzA1 | Cbz1:TEG1 | IC1 | ST1:LiQ (50%:50%) | --- |
| | | 70nm | 5nm | 90nm | 30nm | 10nm | 50nm | |
| N9 | --- | SPA1 | BPA1 | DAS1 | IC2:TEB1 | Ket1 | Alq3 | LiF |
| | | 20nm | 5nm | 15nm | 40nm | 10nm | 20nm | 1nm |
| N10 | --- | SPA1 | BPA1 | DAS1 | IC2:TEB1 | - | Alq3 | LiF |
| | | 20nm | 5nm | 15nm | 40nm | | 30nm | 1nm |
| E1 | --- | SpA1 | HATCN | ICA1 | IC1:Cbz1.TEG1 | IC1 | ST1:LiQ (50%:50%) | --- |
| | | 70nm | 5nm | 90nm | 30nm | 10nm | 30nm | |
| E2 | --- | SpA1 | HATCN | SPA2 | IC1:Cbz1:TEG3 | IC2 | ST1:LiQ (50%:50%) | --- |
| | | 70nm | 5nm | 90nm | 30nm | 10nm | 30nm | |
| E3 | --- | SpA1 | --- | NPB | IC2:Cbz1:TEG1 | --- | ST1:LiQ (50%:50%) | --- |
| | | 200nm | | 20nm | 30nm | | 30nm | |
| E4 | --- | SpA1 | HATCN | BPA1 | IC1 :Cbz2:TEG1 | --- | ST1:LiQ (50%:50%) | --- |
| | | 70nm | 5nm | 90nm | 30nm | | 40nm | |
| E5 | --- | SpA1 | HATCN | SPA2 | IC4:TEG1 | --- | ST1:LiQ (50%:50%) | --- |
| | | 70nm | 5nm | 90nm | 30nm | | 40nm | |
| E6 | --- | SpA1 | HATCN | SPA2 | DAP1:IC2:TEG1 | --- | ST1:LiQ (50%:50%) | --- |
| | | 70nm | 5nm | 90nm | 30nm | | 40nm | |
| E7 | SpA1 | HATCN | BPA1 | DAS1 | IC2:TEG3 | --- | ST1:LiQ (50%:50%) | --- |
| | 70nm | 5nm | 110nm | 20nm | 30nm | | 40nm | |
| E8 | --- | SpA1 | HATCN | BPA1 | IC1:IC5:TEG1 | IC1 | ST1:LiQ (50%:50%) | --- |
| | | 70nm | 5nm | 90nm | 30nm | 10nm | 30nm | |
| E9 | --- | SpA1 | HATCN | ICA1 | IC4:Cbz1:TEG1 | IC1 | ST1:LiQ (50%:50%) | --- |
| | | 70nm | 5nm | 90nm | 30nm | 10nm | 30nm | |
| E10 | --- | SpA1 | --- | NPB | IC2:IC4:TEG1 | --- | ST1:LiQ (50%:50%) | --- |
| | | 200nm | | 20nm | 30nm | | 30nm | |
| E11 | --- | SpA1 | HATCN | ICA1 | IC1:SPA3:TEG1 | IC1 | ST2:LiQ (50%:50%) | --- |
| | | 70nm | 5nm | 90nm | 30nm | 10nm | 30nm | |
| E12 | --- | SpA1 | HATCN | ICA1 | IC1:SPA3:TEG1 | IC1 | ST2 | LiQ |
| | | 70nm | 5nm | 90nm | 30nm | 10nm | 30nm | 3nm |
| E13 | --- | SpA1 | HATCN | SPA2 | IC1:MA1:TEG1 | IC1 | ST2:LiQ (50%:50%) | --- |
| | | 70nm | 5nm | 90nm | 30nm | 10nm | 30nm | |
| E14 | --- | SpA1 | HATCN | SPA2 | IC1:MA1:TEG1 | IC1 | ST2 | LiQ |
| | | 70nm | 5nm | 90nm | 30nm | 10nm | 30nm | 3nm |
| E15 | --- | SpA1 | HATCN | SPA2 | IC1 :Cbz3:TEG1 | IC1 | ST2:LiQ (50%:50%) | --- |
| | | 70nm | 5nm | 90nm | 30nm | 10nm | 30nm | |
| E16 | --- | SpA1 | HATCN | SPA2 | IC1:Cbz3:TEG1 | IC1 | ST2 | LiQ |
| | | 70nm | 5nm | 90nm | 30nm | 10nm | 30nm | 3nm |
| E17 | --- | SpA1 | HATCN | ICA1 | IC1:SPA4:TEG1 | IC1 | ST2:LiQ (50%:50%) | --- |
| | | 70nm | 5nm | 90nm | 30nm | 10nm | 30nm | |
| E18 | --- | SpA1 | HATCN | SPA2 | IC1:SPA5:TEG1 | IC1 | ST2:LiQ (50%:50%) | --- |
| | | 70nm | 5nm | 90nm | 30nm | 10nm | 30nm | |
| E19 | --- | SpA1 | HATCN | SPA2 | IC1:SPA5:TEG1 | IC1 | ST2 | LiQ |
| | | 70nm | 5nm | 90nm | 30nm | 10nm | 30nm | 3nm |
| E20 | --- | SpA1 | HATCN | SPA2 | IC7:TEG1 | IC1 | ST2 | LiQ |
| | | 70nm | 5nm | 90nm | 30nm | 10nm | 30nm | 3nm |

**Tabelle 2: Daten der OLEDs**

| Bsp. | MM1:MM2 | Konz. Emitter | Rel. EQE | Rel. Roll-Off | Rel. LD |
|---|---|---|---|---|---|
| N1 | --- | 3% | 82% | 83% | 33% |
| N1 | --- | 6% | 100% | 95% | 60% |
| N1 | --- | 8% | 98% | 100% | 73% |
| N1 | --- | 10% | 94% | 99% | 100% |
| N2 | --- | 1.5% | 44% | 87% | 100% |
| N2 | --- | 3% | 65% | 85% | 68% |
| N2 | --- | 6% | 90% | 92% | 48% |
| N2 | --- | 10% | 100% | 100% | 46% |
| N3 | --- | 5% | 93% | 87% | 100% |
| N3 | --- | 10% | 100% | 100% | 84% |
| N4 | 1:2 | 4% | 74% | 89% | 55% |
| N4 | 1:2 | 7% | 91% | 93% | 71% |
| N4 | 1:2 | 10% | 100% | 100% | 100% |
| N5 | --- | 5% | 100% | 82% | 63% |
| N5 | --- | 7% | 96% | 88% | 77% |
| N5 | --- | 10% | 92% | 100% | 100% |
| N6 | 2:1 | 3% | 91% | 95% | 82% |
| N6 | 2:1 | 6% | 100% | 100% | 93% |
| N6 | 2:1 | 10% | 96% | 98% | 100% |
| N7 | 1:2 | 4% | 89% | 92% | 83% |
| N7 | 1:2 | 7% | 100% | 97% | 96% |
| N7 | 1:2 | 10% | 98% | 100% | 100% |
| N8 | --- | 1% | 75% | 86% | 14% |
| N8 | --- | 4% | 82% | 97% | 33% |
| N8 | --- | 7% | 100% | 100% | 82% |
| N8 | --- | 10% | 97% | 99% | 100% |
| N9 | --- | 2% | 97% | 99% | 56% |
| N9 | --- | 5% | 100% | 97% | 61% |
| N9 | --- | 8% | 95% | 100% | 78% |
| N9 | --- | 10% | 87% | 98% | 100% |
| N10 | --- | 4% | 88% | 91% | 54% |
| N10 | --- | 7% | 96% | 97% | 79% |
| N10 | --- | 10% | 100% | 100% | 100% |
| E1 | 2:1 | 1% | 97% | 97% | 39% |
| E1 | 2:1 | 4% | 96% | 99% | 97% |
| E1 | 2:1 | 5% | 100% | 97% | 97% |
| E1 | 2:1 | 7% | 96% | 100% | 99% |
| E1 | 2:1 | 10% | 94% | 99% | 100% |
| E2 | 2:1 | 2% | 96% | 93% | 92% |
| E2 | 2:1 | 4% | 100% | 97% | 100% |
| E2 | 2:1 | 6% | 96% | 97% | 94% |
| E2 | 2:1 | 8% | 93% | 99% | 83% |
| E2 | 2:1 | 10% | 92% | 100% | 71% |
| E3 | 6:1 | 4% | 100% | 99% | 100% |
| E3 | 6:1 | 7% | 96% | 100% | 94% |
| E3 | 6:1 | 10% | 91% | 96% | 83% |
| E4 | 2:1 | 4% | 100% | 98% | 100% |
| E4 | 2:1 | 10% | 93% | 100% | 64% |
| E5 | --- | 3% | 96% | 98% | 94% |
| E5 | --- | 6% | 100% | 97% | 100% |
| E5 | --- | 8% | 99% | 100% | 92% |
| E5 | --- | 10% | 96% | 98% | 79% |
| E6 | 1.5:1 | 4% | 100% | 97% | 93% |
| E6 | 1.5:1 | 7% | 95% | 97% | 100% |
| E6 | 1.5:1 | 10% | 93% | 100% | 97% |
| E7 | --- | 5% | 100% | 99% | 100% |
| E7 | --- | 7% | 82% | 100% | 83% |
| E7 | --- | 10% | 70% | 97% | 58% |
| E8 | 8:1 | 2% | 69% | 88% | 38% |
| E8 | 8:1 | 5% | 100% | 99% | 89% |
| E8 | 8:1 | 8% | 99% | 100% | 100% |
| E8 | 8:1 | 10% | 98% | 98% | 77% |
| E9 | 4:1 | 4% | 100% | 97% | 99% |
| E9 | 4:1 | 7% | 99% | 100% | 100% |
| E9 | 4:1 | 10% | 98% | 97% | 94% |
| E10 | 3.5:1 | 6% | 100% | 97% | 100% |
| E10 | 3.5:1 | 8% | 94% | 97% | 88% |
| E10 | 3.5:1 | 10% | 92% | 100% | 82% |
| E11 | 5:1 | 3% | 92% | 93% | 65% |
| E11 | 5:1 | 5% | 98% | 97% | 96% |
| E11 | 5:1 | 7% | 100% | 99% | 98% |
| E11 | 5:1 | 10% | 95% | 100% | 100% |
| E12 | 5:1 | 3% | 92% | 93% | 100% |
| E12 | 5:1 | 5% | 100% | 97% | 98% |
| E12 | 5:1 | 7% | 100% | 99% | 96% |
| E12 | 5:1 | 10% | 99% | 100% | 56% |
| E13 | 2:1 | 3% | 96% | 95% | 85% |
| E13 | 2:1 | 5% | 100% | 98% | 100% |
| E13 | 2:1 | 7% | 98% | 99% | 98% |
| E13 | 2:1 | 10% | 97% | 100% | 98% |
| E14 | 2:1 | 3% | 98% | 97% | 83% |
| E14 | 2:1 | 5% | 99% | 99% | 100% |
| E14 | 2:1 | 7% | 100% | 100% | 96% |
| E14 | 2:1 | 10% | 93% | 99% | 98% |
| E15 | 2.3:1 | 3% | 97% | 99% | 89% |
| E15 | 2.3:1 | 5% | 100% | 99% | 100% |
| E15 | 2.3:1 | 7% | 96% | 100% | 68% |
| E15 | 2.3:1 | 10% | 96% | 100% | 65% |
| E16 | 2.3:1 | 3% | 100% | 98% | 81% |
| E16 | 2.3:1 | 5% | 100% | 99% | 100% |
| E16 | 2.3:1 | 7% | 100% | 100% | 64% |
| E16 | 2.3:1 | 10% | 96% | 100% | 55% |
| E17 | 2.3:1 | 3% | 98% | 94% | 65% |
| E17 | 2.3:1 | 5% | 96% | 98% | 83% |
| E17 | 2.3:1 | 7% | 100% | 99% | 100% |
| E17 | 2.3:1 | 10% | 97% | 100% | 92% |
| E18 | 5:1 | 3% | 93% | 93% | 62% |
| E18 | 5:1 | 5% | 95% | 97% | 91% |
| E18 | 5:1 | 7% | 100% | 99% | 100% |
| E18 | 5:1 | 10% | 92% | 100% | 90% |
| E19 | 5:1 | 3% | 92% | 93% | 100% |
| E19 | 5:1 | 5% | 97% | 97% | 89% |
| E19 | 5:1 | 7% | 100% | 99% | 51% |
| E19 | 5:1 | 10% | 96% | 100% | 43% |
| E20 | --- | 5% | 93% | 100% | 100% |
| E20 | --- | 10% | 100% | 98% | 78% |

**Tabelle 3: Vergleich verschiedener Aufbauten**

| Bsp. | MM1:MM2 | Konz. Emitter | Rel. EQE | Rel. Roll-Off | Rel. LD |
|---|---|---|---|---|---|
| E1 | 2:1 | 7% | 100% | 99% | 83% |
| E9 | 4:1 | 7% | 96% | 100% | 100% |
| E3 | 6:1 | 4% | 95% | 100% | 86% |
| E10 | 3.5:1 | 6% | 100% | 96% | 100% |

**Tabelle 4: Strukturformeln der Materialien für die OLEDs**

| | |
|---|---|
| 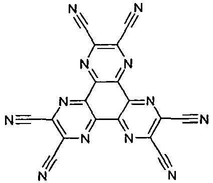 | 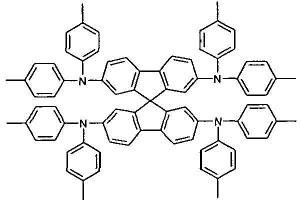 |
| HATCN | SpA1 |
| 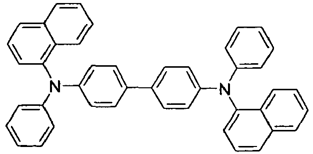 | 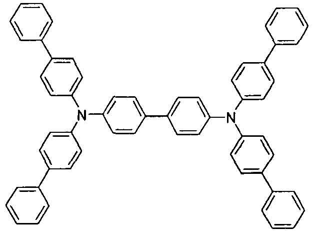 |
| NPB | BPA1 |
| 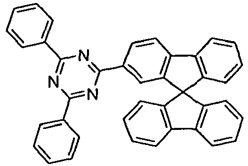 | 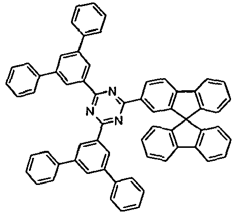 |
| ST1 | ST2 |
| 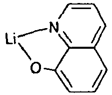 | 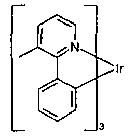 |
| LiQ | TEG1 |
| 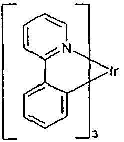 | 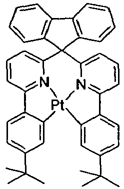 |
| TEG2 | TEG3 |
| 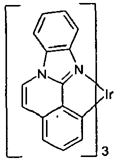 | 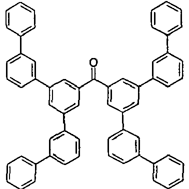 |
| TEB1 | Ket1 |
| 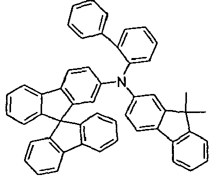 | 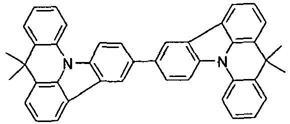 |
| SPA2 | Cbz1 |
| 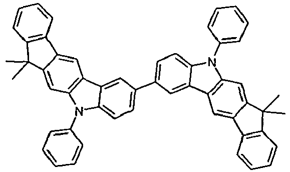 | 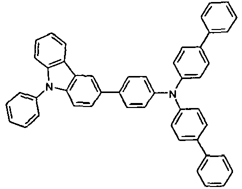 |
| Cbz2 | CbzA1 |
| 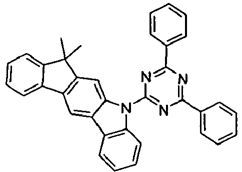 | 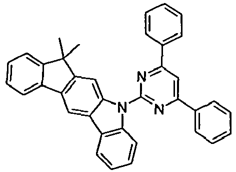 |
| IC1 | IC2 |
| 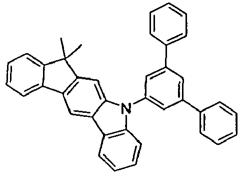 | 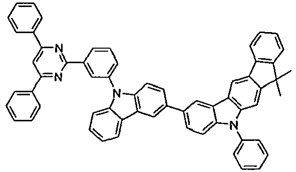 |
| IC3 | IC4 |
| 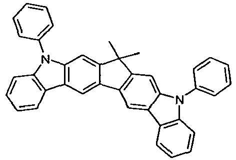 | 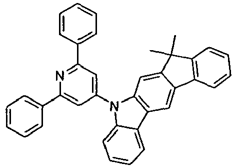 |
| IC5 | IC6 |
| 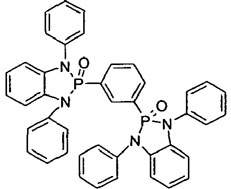 | 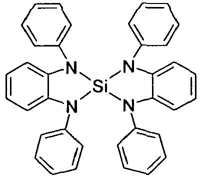 |
| DAP1 | DAS1 |
| 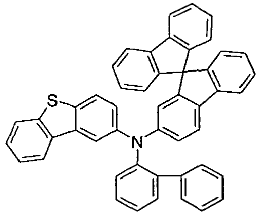 | 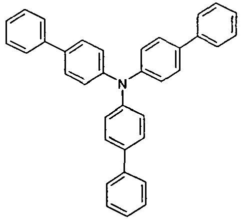 |
| SPA3 | MA1 |
| 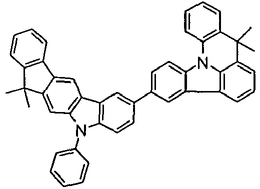 | 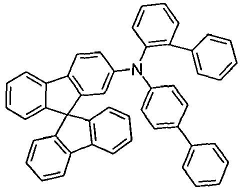 |
| Cbz3 | SPA4 |
| 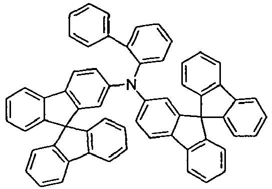 | 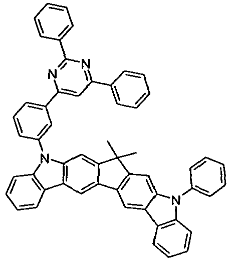 |
| SPA5 | IC7 |
| 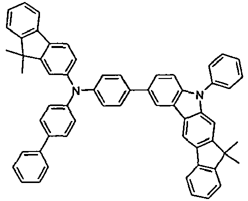 | |
| ICA1 | |

**Tabelle 5: HOMO/LUMO-Werte und Triplettniveaus T₁ der Materialien**

| Material | HOMO (eV) | LUMO (eV) | T₁(eV) | Methode |
|---|---|---|---|---|
| BPA1 | -5.14 | -2.27 | 2.52 | orq. |
| NPB | -5.16 | -2.28 | 2.45 | org. |
| CbzA1 | -5.18 | -2.15 | 2.66 | org. |
| IC1 | -5.79 | -2.83 | 2.69 | orq. |
| IC2 | -5.62 | -2.75 | 2.75 | org. |
| IC3 | -5.54 | -2.27 | 2.82 | org. |
| IC4 | -5.46 | -2.70 | 2.78 | org. |
| IC5 | -5.29 | -2.13 | 2.73 | org. |
| IC6 | -5.71 | -2.42 | 2.81 | org. |
| IC7 | -5.31 | -2.72 | 2.70 | org. |
| ST1 | -6.05 | -2.79 | 2.70 | org. |
| ST2 | -6.03 | -2.82 | 2.68 | org. |
| SPA2 | -5.25 | -2.18 | 2.58 | org. |
| SPA3 | -5.31 | -2.21 | 2.65 | org. |
| SPA4 | -5.31 | -2.16 | 2.64 | org. |
| SPA5 | -5.25 | -2.19 | 2.57 | org. |
| MA1 | -5.26 | -2.17 | 2.67 | org. |
| Cbz1 | -5.37 | -2.14 | 2.86 | org. |
| Cbz2 | -5.37 | -2.11 | 2.79 | org. |
| Cbz3 | -5.37 | -2.12 | 2.80 | org. |
| ICA1 | -5.12 | -2.21 | 2.51 | org. |
| DAP1 | -5.56 | -2.50 | 3.03 | org. |
| DAS1 | -5.43 | -1.81 | 3.25 | org. |
| Ket1 | -6.32 | -2.79 | 2.79 | org. |
| TEG1 | -5.21 | -2.26 | 2.68 | M-org. |
| TEG2 | -5.30 | -2.35 | 2.71 | M-org. |
| TEG3 | -5.60 | -2.59 | 2.58 | M-org. |
| TEB1 | -5.23 | -2.14 | 2.89 | M-org. |
| LiQ | -5.17 | -2.39 | 2.13 | M-org. |

## Patentansprüche

1. Organische Elektrolumineszenzvorrichtung mit einem Emissionsmaximum von ≤ 570 nm enthaltend in dieser Reihefolge eine Anode, eine Elektronenblockierschicht (EBL), eine phosphoreszierende Emissionsschicht (EML), welche mindestens eine phosphoreszierende Verbindung und mindestens ein Matrixmaterial enthält, wobei die Gesamtkonzentration aller phosphoreszierenden Verbindungen < 10 Vol.% ist, eine Lochblockierschicht (HBL) und eine Kathode, wobei die Elektrolumineszenzvorrichtung zwischen der emittierenden Schicht und der Kathode keinen Aluminiummetallkomplex enthält, **dadurch gekennzeichnet, dass** für die Schichten gilt:
a) $HOMO \left(EBL\right) - HOMO \left(EML\right) \leq 0.4 eV ;$
b) $LUMO \left(EML\right) - LUMO \left(HBL\right) \leq 0.4 eV ;$
c) $HOMO aller Matrixmaterialien der EML \geq - 6.0 eV ;$ und
d) $LUMO \left(EML\right) \leq - 2.5 eV ;$
wobei HOMO(EBL) das HOMO des Materials der Elektronenblockierschicht darstellt, HOMO(EML) das HOMO des Matrixmaterials der Emissionsschicht darstellt, LUMO(EML) das LUMO des Matrixmaterials der Emissionsschicht und LUMO(HBL) das LUMO des Materials der Lochblockierschicht darstellt; bei Verwendung mehrerer Matrixmaterialien ist HOMO(EML) das am höchsten liegende HOMO der Matrixkomponenten und ist LUMO(EML) das am tiefsten liegende LUMO der Matrixkomponenten;
dabei werden die HOMO und LUMO-Lagen wie folgt über quantenchemische Rechnungen mit dem Programmpaket "Gaussian03W" (Gaussian Inc.) bestimmt: Zur Berechnung organischer Substanzen ohne Metalle wird zuerst eine Geometrieoptimierung mit der Methode "Ground State/Semi-empirical/Default Spin/AM1/Charge 0/Spin Singlet" durchgeführt, gefolgt von einer Energierechnung auf Grundlage der optimierten Geometrie mit der Methode "TD-SFC/DFT/Default Spin/B3PW91" mit dem Basissatz "6-31 G(d)" (Charge 0, Spin Singlet); für metallorganische Verbindungen wird die Geometrie über die Methode "Ground State/ Hartree-Fock/Default Spin/LanL2MB/Charge 0/Spin Singlet" optimiert, gefolgt von einer Energierechnung analog zu den organischen Substanzen, wie oben beschrieben, mit dem Unterschied, dass für das Metallatom der Basissatz "LanL2DZ" und für die Liganden der Basissatz "6-31G(d)" verwendet wird; aus dem aus der Energierechnung erhaltenen HOMO HEh bzw. LUMO LEh in Hartree-Einheiten werden die HOMO und LUMO Werte in Elektronenvolt gemäß der folgenden Formel bestimmt: $HOMO \left(eV\right) = \left(\left(HEh*27.212\right)-0.9899\right) / 1.1206$ $LUMO \left(eV\right) = \left(\left(LEh*27.212\right)-2.0041\right) / 1.385 .$

2. Organische Elektrolumineszenzvorrichtung nach Anspruch 1, **dadurch gekennzeichnet, dass** die Gesamtkonzentration aller phosphoreszierenden Verbindungen in der emittierenden Schicht zwischen 1 und 9 Vol.% und bevorzugt zwischen 2 und 8 Vol.% liegt.

3. Organische Elektrolumineszenzvorrichtung nach Anspruch 1 oder 2, **dadurch gekennzeichnet, dass** gilt:
a) $HOMO \left(Emitter\right) - HOMO \left(EML\right) \leq 0.3 eV ;$ und
b) $LUMO \left(EML\right) - LUMO \left(Emitter\right) \leq 0.3 eV ,$ wobei HOMO(Emitter) bzw. LUMO(Emitter) das HOMO bzw. das LUMO des phosphoreszierenden Emitters darstellt.

4. Organische Elektrolumineszenzvorrichtung nach einem oder mehreren der Ansprüche 1 bis 3 mit einem Emissionsmaximum von ≤ 560 nm, welche in der Emissionsschicht eine Gesamtkonzentration aller phosphoreszierenden Verbindungen zwischen 1 und 9 Vor.% enthält und welche zwischen der Emissionsschicht und der Kathode keinen Aluminiummetallkomplex enthält, **dadurch gekennzeichnet, dass** für die Schichten gilt:
a) $HOMO \left(EBL\right) - HOMO \left(EML\right) \leq 0.35 eV ;$
b) $LUMO \left(EML\right) - LUMO \left(HBL\right) \leq 0.35 eV ;$
c) $HOMO aller Matrixmaterialien der EML \geq - 5.9 eV ;$ und
d) $LUMO \left(EML\right) \leq - 2.55 eV .$

5. Organische Elektrolumineszenzvorrichtung nach einem oder mehreren der Ansprüche 1 bis 4 mit einem Emissionsmaximum von ≤ 550 nm, welche in der Emissionsschicht eine Gesamtkonzentration aller phosphoreszierenden Verbindungen zwischen 2 und 8 Vol.% enthält und welche zwischen der Emissionsschicht und der Kathode keinen Aluminiummetallkomplex enthält, **dadurch gekennzeichnet, dass** für die Schichten gilt:
a) $HOMO \left(EBL\right) - HOMO \left(EML\right) \leq 0.3 eV ;$
b) $LUMO \left(EML\right) - LUMO \left(HBL\right) \leq 0.3 eV ;$
c) $HOMO aller Matrixmaterialien der EML \geq - 5 ⁢ .8 eV ;$ und
d) $LUMO \left(EML\right) \leq - 2.6 eV .$

6. Organische Elektrolumineszenzvorrichtung nach einem oder mehreren der Ansprüche 1 bis 5 mit einem Emissionsmaximum von ≤ 540 nm, welche in der Emissionsschicht eine Gesamtkonzentration aller phosphoreszierenden Verbindungen zwischen 3 und 7 Vol % enthält und welche zwischen der Emissionsschicht und der Kathode keinen Aluminiummetallkomplex enthält, **dadurch gekennzeichnet, dass** für die Schichten gilt:
a) $HOMO \left(EBL\right) - HOMO \left(EML\right) \leq 0.25 eV ;$
b) $LUMO \left(EML\right) - LUMO \left(HBL\right) \leq 0.25 eV ;$
c) $HOMO aller Matrixmaterialien der EML \geq - 5.8 eV ;$ und
d) $LUMO \left(EML\right) \leq - 2.6 eV .$

7. Organische Elektrolumineszenzvorrichtung nach einem oder mehreren der Ansprüche 1 bis 6, **dadurch gekennzeichnet, dass** HOMO(EBL) ≥ - 5.5 eV ist.

8. Organische Elektrolumineszenzvorrichtung nach einem oder mehreren der Ansprüche 1 bis 7, **dadurch gekennzeichnet, dass** gilt: ${T}_{1} \left(Emitter\right) - {T}_{1} \left(Matrix\right) \leq 0.2 eV ,$ wobei T₁(Matrix) das Triplettniveau des Matrixmaterials darstellt und T₁(Emitter) das Triplettniveau des phosphoreszierenden Emitters darstellt und das Triplettniveau T₁ definiert ist als die Energie des Triplettzustands mit der niedrigsten Energie, die sich aus der quantenchemischen Rechnung wie in Anspruch 1 definiert ergibt; bei Verwendung mehrerer Matrixmaterialien gilt die oben genannte Beziehung für jedes der Matrixmaterialien.

9. Organische Elektrolumineszenzvorrichtung nach einem oder mehreren der Ansprüche 1 bis 8, **dadurch gekennzeichnet, dass** gilt:
a) ${T}_{1} \left(Emitter\right) - {T}_{1} \left(EBL\right) \leq 0.3 eV$ und
b) ${T}_{1} \left(Emitter\right) - {T}_{1} \left(HBL\right) \leq 0.3 eV ,$ wobei T₁(EBL) das Triplettniveau des Materials der Elektronenblockierschicht darstellt und T₁(HBL) das Triplettniveau des Materials der Lochblockierschicht darstellt und das Triplettniveau T₁ definiert ist als die Energie des Triplettzustands mit der niedrigsten Energie, die sich aus der quantenchemischen Rechnung wie in Anspruch 1 definiert ergibt.

10. Organische Elektrolumineszenzvorrichtung nach einem oder mehreren der Ansprüche 1 bis 9, **dadurch gekennzeichnet, dass**, wenn zwei oder mehr Matrixmaterialien verwendet werden, die Konzentration der Komponente mit dem höchsten HOMO zwischen 4 und 50 Vol.% beträgt-

11. Organische Elektrolumineszenzvorrichtung nach einem oder mehreren der Ansprüche 1 bis 10, **dadurch gekennzeichnet, dass** gilt: LUMO(EBL) - LUMO(EML) ≥ 0.2 eV.

12. Organische Elektrolumineszenzvorrichtung nach einem oder mehreren der Ansprüche 1 bis 11, **dadurch gekennzeichnet, dass** gilt: HOMO(EML) - HOMO(HBL) ≥ 0.2 eV.

13. Organische Elektrolumineszenzvorrichtung nach einem oder mehreren der Ansprüche 1 bis 12, **dadurch gekennzeichnet, dass**, wenn zwei oder mehr Matrixmaterialien verwendet werden, die Komponente des Matrixmaterials mit dem höchsten HOMO ausgewählt ist aus der Gruppe bestehend aus Triarylaminderivaten, verbrückten Triarylaminderivaten, Carbazolderivaten, Azacarbazolderivaten, kondensierten Carbazolderivaten, Diaza- bzw. Tetraazasilolderivaten und Dibenzofuranbzwl Benzofuranyldibenzofuran-Derivaten.

14. Organische Elektrolumineszenzvorrichtung nach einem oder mehreren der Ansprüche 1 bis 13, **dadurch gekennzeichnet, dass**, wenn zwei oder mehr Matrixmaterialien verwendet werden, die Komponente des Matrixmaterials mit dem tiefsten LUMO ausgewählt ist aus der Gruppe bestehend aus aromatischen Ketonen, aromatischen Phosphinoxiden, aromatischen Sulfoxiden oder Sulfonen, Silanen, Azaborolen, Boronestern, Triazinderivaten, Pyrimidinderivaten, Diazaphospholderivaten, Indolocarbazolderivate, die mit elektronenarmen Heteroaromaten substituiert sind, oder Indenocarbazolderivaten, die mit elektronenarmen Heteroaromaten substituiert sind.

## Claims

1. Organic electroluminescent device having an emission maximum of ≤ 570 nm comprising, in this sequence, an anode, an electron-blocking layer (EBL), a phosphorescent emission layer (EML) which comprises at least one phosphorescent compound and at least one matrix material, where the total concentration of all phosphorescent compounds is < 10% by vol., a hole-blocking layer (HBL) and a cathode, where the electroluminescent device comprises no aluminium metal complex between the emitting layer and the cathode, **characterised in that** the following applies to the layers:
a) $HOMO \left(EBL\right) - HOMO \left(EML\right) \leq 0.4 eV ;$
b) $LUMO \left(EML\right) - LUMO \left(HBL\right) \leq 0.4 eV ;$
c) $HOMO of all matrix mateirals of the EML \geq - 6.0 eV ;$ and
d) $LUMO \left(EML\right) \leq - 2.5 eV ;$
where HOMO(EBL) represents the HOMO of the material of the electron-blocking layer, HOMO(EML) represents the HOMO of the matrix material of the emission layer, LUMO(EML) represents the LUMO of the matrix material of the emission layer and LUMO(HBL) represents the LUMO of the material of the hole-blocking layer; on use of a plurality of matrix materials, HOMO(EML) is the highest HOMO of the matrix components and LUMO(EML) is the lowest LUMO of the matrix components;
the HOMO and LUMO positions are determined as follows via quantum-chemical calculations using the "Gaussian03W" software package (Gaussian Inc.): for the calculation of organic substances without metals, firstly a geometry optimisation is carried out using the "Ground State/Semi-empirical/Default Spin/AM1/Charge 0/Spin Singlet" method, followed by an energy calculation on the basis of the optimised geometry using the "TD-SFC/DFT/Default Spin/B3PW91" method with the "6-31G(d)" base set (Charge 0, Spin Singlet); for organometallic compounds, the geometry is optimised via the "Ground State/Hartree-Fock/Default Spin/LanL2MB/Charge 0/Spin Singlet" method, followed by an energy calculation analogously to the organic substances, as described above, with the difference that the "LanL2DZ" base set is used for the metal atom and the "6-31G(d)" base set is used for the ligands; the HOMO and LUMO values in electron volts are determined in accordance with the following formula from the HOMO HEh or LUMO LEh in hartree units obtained from the energy calculation: $HOMO \left(eV\right) = \left(\left(HEh*27.212\right)-0.9899\right) / 1.1206$ $LUMO \left(eV\right) = \left(\left(LEh*27.212\right)-2.0041\right) / 1.385 .$

2. Organic electroluminescent device according to Claim 1, **characterised in that** the total concentration of all phosphorescent compounds in the emitting layer is between 1 and 9% by vol. and preferably between 2 and 8% by vol.

3. Organic electroluminescent device according to Claim 1 or 2, **characterised in that** the following applies:
a) $HOMO \left(emitter\right) - HOMO \left(EML\right) \leq 0.3 eV ;$ and
b) $LUMO \left(EML\right) - LUMO \left(emitter\right) \leq 0.3 eV ,$ where HOMO(emitter) and LUMO(emitter) represent the HOMO and LUMO respectively of the phosphorescent emitter.

4. Organic electroluminescent device according to one or more of Claims 1 to 3 having an emission maximum of ≤ 560 nm which contains a total concentration of all phosphorescent compounds of between 1 and 9% by vol. in the emission layer and which contains no aluminium metal complex between the emission layer and the cathode, **characterised in that** the following applies to the layers:
a) $HOMO \left(EBL\right) - HOMO \left(EML\right) \leq 0.35 eV ;$
b) $LUMO \left(EML\right) - LUMO \left(HBL\right) \leq 0.35 eV ;$
c) $HOMO of all matrix materials of the EML \geq - 5.9 eV ;$ and
d) $LUMO \left(EML\right) \leq - 2.55 eV .$

5. Organic electroluminescent device according to one or more of Claims 1 to 4 having an emission maximum of ≤ 550 nm which contains a total concentration of all phosphorescent compounds of between 2 and 8% by vol. in the emission layer and which contains no aluminium metal complex between the emission layer and the cathode, **characterised in that** the following applies to the layers:
a) $HOMO \left(EBL\right) - HOMO \left(EML\right) \leq 0.3 eV ;$
b) $LUMO \left(EML\right) - LUMO \left(HBL\right) \leq 0.3 eV ;$
c) $HOMO of all matrix materials of the EML \geq - 5.8 eV ;$ and
d) $LUMO \left(EML\right) \leq - 2.6 eV .$

6. Organic electroluminescent device according to one or more of Claims 1 to 5 having an emission maximum of ≤ 540 nm which contains a total concentration of all phosphorescent compounds of between 3 and 7% by vol. in the emission layer and which contains no aluminium metal complex between the emission layer and the cathode, **characterised in that** the following applies to the layers:
a) $HOMO \left(EBL\right) - HOMO \left(EML\right) \leq 0.25 eV ;$
b) $LUMO \left(EML\right) - LUMO \left(HBL\right) \leq 0.25 eV ;$
c) $HOMO of all matrix materials of the EML \geq - 5.8 eV ;$ and
d) $LUMO \left(EML\right) \leq - 2.6 eV .$

7. Organic electroluminescent device according to one or more of Claims 1 to 6, **characterised in that** HOMO(EBL) is ≥ -5.5 eV.

8. Organic electroluminescent device according to one or more of Claims 1 to 7, **characterised in that** the following applies: ${T}_{1} \left(emitter\right) - {T}_{1} \left(matrix\right) \leq 0.2 eV ,$ where T₁(matrix) represents the triplet level of the matrix material and T₁(emitter) represents the triplet level of the phosphorescent emitter and the triplet level T₁ is defined as the energy of the triplet state having the lowest energy which arises from the quantum-chemical calculation as defined in Claim 1; on use of a plurality of matrix materials, the above-mentioned relationship applies to each of the matrix materials.

9. Organic electroluminescent device according to one or more of Claims 1 to 8, **characterised in that** the following applies:
a) ${T}_{1} \left(emitter\right) - {T}_{1} \left(EBL\right) \leq 0.3 eV$ and
b) ${T}_{1} \left(emitter\right) - {T}_{1} \left(EBL\right) \leq 0.3 eV ,$ where T₁(EBL) represents the triplet level of the material of the electron-blocking layer and T₁(HBL) represents the triplet level of the material of the hole-blocking layer and the triplet level T₁ is defined as the energy of the triplet state having the lowest energy which arises from the quantum-chemical calculation as defined in Claim 1.

10. Organic electroluminescent device according to one or more of Claims 1 to 9, **characterised in that**, if two or more matrix materials are used, the concentration of the component having the highest HOMO is between 4 and 50% by vol.

11. Organic electroluminescent device according to one or more of Claims 1 to 10, **characterised in that** the following applies: LUMO(EBL) - LUMO(EML) ≥ 0.2 eV.

12. Organic electroluminescent device according to one or more of Claims 1 to 11, **characterised in that** the following applies: HOMO(EML) - HOMO(HBL) ≥ 0.2 eV.

13. Organic electroluminescent device according to one or more of Claims 1 to 12, **characterised in that**, if two or more matrix materials are used, the component of the matrix material having the highest HOMO is selected from the group consisting of triarylamine derivatives, bridged triarylamine derivatives, carbazole derivatives, azacarbazole derivatives, condensed carbazole derivatives, diaza- and tetraazasilole derivatives and dibenzofuran and benzofuranyldibenzofuran derivatives.

14. Organic electroluminescent device according to one or more of Claims 1 to 13, **characterised in that**, if two or more matrix materials are used, the component of the matrix material having the lowest LUMO is selected from the group consisting of aromatic ketones, aromatic phosphine oxides, aromatic sulfoxides or sulfones, silanes, azaboroles, boronic esters, triazine derivatives, pyrimidine derivatives, diazaphosphole derivatives, indolocarbazole derivatives which are substituted by electron-deficient heteroaromatics, or indenocarbazole derivatives which are substituted by electron-deficient heteroaromatics.

## Revendications

1. Dispositif électroluminescent organique présentant un maximum d'émission ≤ 570 nm et comprenant, selon cette séquence, une anode, une couche de blocage d'électrons (EBL), une couche d'émission phosphorescente (EML), laquelle comprend au moins un composé phosphorescent et au moins un matériau de matrice, où la concentration totale de tous les composés phosphorescents est < 10% en volume, une couche de blocage de trous (HBL) et une cathode, où le dispositif électroluminescent ne comprend pas de complexe métallique d'aluminium entre la couche d'émission et la cathode, **caractérisé en ce que** ce qui suit s'applique aux couches :
a) $HOMO \left(EBL\right) - HOMO \left(EML\right) \leq 0,4 eV ;$
b) $LUMO \left(EML\right) - LUMO \left(HBL\right) \leq 0,4 eV ;$
c) $HOMO de tous les matériaux de matrice de l'EML \geq - 6.0 eV ;$ et
d) $LUMO \left(EML\right) \leq - 2,5 eV ;$
où HOMO(EBL) représente la HOMO du matériau de la couche de blocage d'électrons, HOMO(EML) représente la HOMO du matériau de matrice de la couche d'émission, LUMO(EML) représente la LUMO du matériau de matrice de la couche d'émission et LUMO(HBL) représente la LUMO du matériau de la couche de blocage de trous ; lors de l'utilisation d'une pluralité de matériaux de matrice, HOMO(EML) est la HOMO la plus haute des composants de matrice et LUMO(EML) est la LUMO la plus basse des composants de matrice ;
les positions de la HOMO et de la LUMO sont déterminées comme suit via des calculs de la chimie quantique en utilisant le progiciel "Gaussian03W" (Gaussian Inc.) : pour le calcul des substances organiques sans métaux, en premier lieu, une optimisation de géométrie est mise en œuvre en utilisant le procédé "Ground State/Semi-empirical/Default Spin/AM1/Charge 0/Spin Singlet", suivi par un calcul d'énergie sur la base de la géométrie optimisée en utilisant le procédé "TD-SFC/DFT/Default Spin/B3PW91" avec le jeu de base "6-31G(d)" (Charge 0, Spin Singlet) ; pour les composés organométalliques, la géométrie est optimisée via le procédé "Ground State/Hartree-Fock/ Default Spin/LanL2MB/Charge 0/Spin Singlet", suivi par un calcul d'énergie de façon analogue aux substances organiques, comme il a été décrit ci-avant, la différence étant que le jeu de base "LanL2DZ" est utilisé pour l'atome de métal et le jeu de base "6-31G(d)" est utilisé pour les ligands ; les valeurs de la HOMO et de la LUMO en électronvolts sont déterminées conformément à la formule qui suit à partir de HOMO HEh ou de LUMO LEh selon des unités de Hartree qui sont obtenues à partir du calcul d'énergie : $HOMO \left(eV\right) = \left(\left(HEh*27,212\right)-0,9899\right) / 1,1206$ $LUMO \left(eV\right) = \left(\left(LEh*27,212\right)-2,0041\right) / 1,385 .$

2. Dispositif électroluminescent organique selon la revendication 1, **caractérisé en ce que** la concentration totale de tous les composés phosphorescents dans la couche d'émission est entre 1 et 9% en volume et de préférence, entre 2 et 8% en volume.

3. Dispositif électroluminescent organique selon la revendication 1 ou 2, **caractérisé en ce que** ce qui suit s'applique :
a) $HOMO \left(émetteur\right) - HOMO \left(EML\right) \leq 0,3 eV ;$ et
b) $LUMO \left(EML\right) - LUMO \left(émetteur\right) \leq 0,3 eV ,$ où HOMO(émetteur) et LUMO(émetteur) représentent respectivement la HOMO et la LUMO de l'émetteur phosphorescent.

4. Dispositif électroluminescent organique selon une ou plusieurs des revendications 1 à 3 présentant un maximum d'émission ≤ 560 nm, lequel contient une concentration totale de tous les composés phosphorescents entre 1 et 9% en volume dans la couche d'émission et lequel ne contient pas de complexe métallique d'aluminium entre la couche d'émission et la cathode, **caractérisé en ce que** ce qui suit s'applique aux couches :
a) $HOMO \left(EBL\right) - HOMO \left(EML\right) \leq 0,35 eV ;$
b) $LUMO \left(EML\right) - LUMO \left(HBL\right) \leq 0,35 eV ;$
c) $HOMO de tous les matériauw de matrice de l'EML \geq - 5,9 eV;$ et
d) $LUMO \left(EML\right) \leq 2,55 eV .$

5. Dispositif électroluminescent organique selon une ou plusieurs des revendications 1 à 4 présentant un maximum d'émission ≤ 550 nm, lequel contient une concentration totale de tous les composés phosphorescents entre 2 et 8% en volume dans la couche d'émission et lequel ne contient pas de complexe métallique d'aluminium entre la couche d'émission et la cathode, **caractérisé en ce que** ce qui suit s'applique aux couches :
a) $HOMO \left(EBL\right) - HOMO \left(EML\right) \leq 0,3 eV ;$
b) $LUMO \left(EML\right) - LUMO \left(HBL\right) \leq 0,3 eV ;$
c) $HOMO de tous les matériaux de matrice de l'EML \geq - 5,8 eV ;$ et
d) $LUMO \left(EML\right) \leq - 2,6 eV .$

6. Dispositif électroluminescent organique selon une ou plusieurs des revendications 1 à 5 présentant un maximum d'émission ≤ 540 nm, lequel contient une concentration totale de tous les composés phosphorescents entre 3 et 7% en volume dans la couche d'émission et lequel ne contient pas de complexe métallique d'aluminium entre la couche d'émission et la cathode, **caractérisé en ce que** ce qui suit s'applique aux couches :
a) $HOMO \left(EBL\right) - HOMO \left(EML\right) \leq 0,25 eV ;$
b) $LUMO \left(EML\right) - LUMO \left(HBL\right) \leq 0,25 eV ;$
c) $HOMO de tous les matériaux de matrice de l'EML \geq - 5,8 eV ;$ et
d) $LUMO \left(EML\right) \leq - 2,6 eV .$

7. Dispositif électroluminescent organique selon une ou plusieurs des revendications 1 à 6, **caractérisé en ce que** HOMO(EBL) ≥ -5,5 eV.

8. Dispositif électroluminescent organique selon une ou plusieurs des revendications 1 à 7, **caractérisé en ce que** ce qui suit s'applique : ${T}_{1} \left(émetteur\right) - {T}_{1} \left(matrice\right) \leq 0,2 eV ,$ où T₁(matrice) représente le niveau de triplet du matériau de matrice et T₁(émetteur) représente le niveau de triplet de l'émetteur phosphorescent et le niveau de triplet T₁ est défini en tant qu'énergie de l'état de triplet présentant l'énergie la plus faible qui résulte du calcul de la chimie quantique tel qu'il a été défini selon la revendication 1 ; lors de l'utilisation d'une pluralité de matériaux de matrice, la relation qui a été mentionnée ci-avant s'applique à chacun des matériaux de matrice.

9. Dispositif électroluminescent organique selon une ou plusieurs des revendications 1 à 8, **caractérisé en ce que** ce qui suit s'applique :
a) ${T}_{1} \left(émetteur\right) - {T}_{1} \left(EBL\right) \leq 0,3 eV ;$ et
b) ${T}_{1} \left(émetteur\right) - {T}_{1} \left(HBL\right) \leq 0,3 eV ,$ où T₁(EBL) représente le niveau de triplet du matériau de la couche de blocage d'électrons et T₁(HBL) représente le niveau de triplet du matériau de la couche de blocage de trous et le niveau de triplet T₁ est défini en tant qu'énergie de l'état de triplet qui présente le niveau d'énergie le plus faible qui résulte du calcul de la chimie quantique tel qu'il a été défini selon la revendication 1.

10. Dispositif électroluminescent organique selon une ou plusieurs des revendications 1 à 9, **caractérisé en ce que**, si deux matériaux de matrice ou plus sont utilisés, la concentration du composant qui présente la HOMO la plus haute est entre 4 et 50% en volume.

11. Dispositif électroluminescent organique selon une ou plusieurs des revendications 1 à 10, **caractérisé en ce que** ce qui suit s'applique : $LUMO \left(EBL\right) - LUMO \left(EML\right) \geq 0,2 eV .$

12. Dispositif électroluminescent organique selon une ou plusieurs des revendications 1 à 11, **caractérisé en ce que** ce qui suit s'applique : $HOMO \left(EML\right) - HOMO \left(HBL\right) \geq 0,2 eV .$

13. Dispositif électroluminescent organique selon une ou plusieurs des revendications 1 à 12, **caractérisé en ce que**, si deux matériaux de matrice ou plus sont utilisés, le composant du matériau de matrice qui présente la HOMO la plus haute est sélectionné parmi le groupe qui est constitué par les dérivés de triarylamine, les dérivés de triarylamine pontés, les dérivés de carbazole, les dérivés d'azacarbazole, les dérivés de carbazole condensés, les dérivés de diaza- et tétraazasilole et les dérivés de dibenzofurane et de benzofuranyldibenzofurane.

14. Dispositif électroluminescent organique selon une ou plusieurs des revendications 1 à 13, **caractérisé en ce que**, si deux matériaux de matrice ou plus sont utilisés, le composant du matériau de matrice qui présente la LUMO la plus basse est sélectionné parmi le groupe qui est constitué par les cétones aromatiques, les oxydes de phosphine aromatiques, les sulfoxydes ou les sulfones aromatiques, les silanes, les azaboroles, les esters boroniques, les dérivés de triazine, les dérivés de pyrimidine, les dérivés de diazaphosphole, les dérivés d'indolocarbazole qui sont substitués par des hétéroaromates déficients en électrons, ou les dérivés d'indénocarbazole qui sont substitués par des hétéroaromates déficients en électrons.
